# EUROPEAN PATENT APPLICATION

(11) **EP 4 557 609 A1**
(43) Date of publication of application: **21.05.2025**
(21) Application number: 23868128.2
(22) Date of filing: 14.09.2023
(51) Int. Cl.: H03F 1/02, H03F 3/24

(54) **TRACKER CIRCUIT AND TRACKING METHOD**

(30) Priority: 22.09.2022 US 202263408981 P
(71) Applicant: Murata Manufacturing Co., Ltd., Nagaokakyo-shi, Kyoto 617-8555 (JP)
(72) Inventor: HOVERSTEN, John, Cambridge, Massachusetts 02142 (US); PERREAULT, David, Cambridge, Massachusetts 02142 (US); KATO, Muneharu, Nagaokakyo-shi, Kyoto 617-8555 (JP)
(74) Representative: Stöckeler, Ferdinand
(86) International application number: PCT/JP2023/033564
(87) International publication number: WO 2024/063007

(57) **Abstract**

A tracker circuit (1A) includes an output switching circuit (30), a voltage supply path (P41), a voltage supply path (P42), and a filter circuit (40A). The output switching circuit (30) is configured to selectively output at least one of a plurality of discrete voltages to power amplifiers (2A and 2B). The power amplifier (2A) is configured to amplify a radio frequency signal (RF_{A}) of Band (A). The power amplifier (2B) is configured to amplify a radio frequency signal (RF_{B}) of Band (B). The voltage supply path (P41) connects the output switching circuit (30) and the power amplifier (2A). The voltage supply path (P42) connects the output switching circuit (30) and the power amplifier (2B). The filter circuit (40A) is connectable in shunt with the voltage supply paths (P41 and P42).

## Description

The present invention relates to a tracker circuit and a tracking method.

### Background Art

An envelope tracking (ET) mode has been used in recent years for power amplifiers to improve power-added efficiency (PAE). Patent Document 1 discloses a technique related to a digital ET mode that supplies a plurality of discrete voltages. Patent Document 2 discloses a technique related to a symbol power tracking (SPT) mode that supplies a plurality of discrete voltages.

### Citation List

### Patent Document

Patent Document 1: U.S. Patent No. 8829993
Patent Document 2: U.S. Patent No. 10686407

### Summary of Invention

### Technical Problem

The techniques according to the related art mentioned above, however, may result in increased distortion of a radio frequency signal in power amplifiers.

Accordingly, the present invention provides a tracker circuit and a tracking method that allow for reduced distortion of a radio frequency signal amplified by using a plurality of discrete voltages.

### Solution to Problem

A tracker circuit according to an aspect of the present invention includes an output switching circuit, a first voltage supply path, a second voltage supply path, and a first filter circuit. The output switching circuit is configured to selectively output at least one of a plurality of discrete voltages to a first power amplifier and a second power amplifier. The first power amplifier is configured to amplify a first radio frequency signal of a first band. The second power amplifier is configured to amplify a second radio frequency signal of a second band. The first voltage supply path connects the output switching circuit and the first power amplifier. The second voltage supply path connects the output switching circuit and the second power amplifier. The first filter circuit is connectable in shunt with the first voltage supply path and the second voltage supply path.

A tracker circuit according to an aspect of the present invention includes a first external connection terminal, a second external connection terminal, an output switching circuit, a first voltage supply path, a second voltage supply path, and a first filter circuit. The first external connection terminal is connected to a first power amplifier. The second external connection terminal is connected to a second power amplifier. The output switching circuit is configured to selectively output at least one of a plurality of discrete voltages to the first external connection terminal and the second external connection terminal. The first voltage supply path connects the output switching circuit and the first external connection terminal. The second voltage supply path connects the output switching circuit and the second external connection terminal. The first filter circuit is connected between the first voltage supply path and ground, and connected between the second voltage supply path and ground.

A tracking method according to an aspect of the present invention includes: in a case where a first radio frequency signal of a first band is to be amplified by a first power amplifier, (i) not connecting a filter circuit to a first voltage supply path when the first radio frequency signal has a channel band width greater than or equal to a threshold band width, and connecting the filter circuit to the first voltage supply path when the first radio frequency signal has a channel band width less than the threshold band width, and (ii) selectively supplying at least one of a plurality of discrete voltages to the first power amplifier via the first voltage supply path; and in a case where a second radio frequency signal of a second band is to be amplified by a second power amplifier, (i) connecting the filter circuit to a second voltage supply path, and (ii) selectively supplying at least one of a plurality of discrete voltages to the second power amplifier via the second voltage supply path.

### Advantageous Effects of Invention

A tracker circuit and other techniques according to an aspect of the present invention allow for reduced distortion of a radio frequency signal amplified by using a plurality of discrete voltages.

### Brief Description of Drawings

[Fig. 1A] Fig. 1A is a graph illustrating an example of the progression of power supply voltage in an average power tracking (APT) mode.
[Fig. 1B] Fig. 1B is a graph illustrating an example of the progression of power supply voltage in an analog ET mode.
[Fig. 1C] Fig. 1C is a graph illustrating an example of the progression of power supply voltage in a digital ET mode.
[Fig. 2] Fig. 2 is a circuit diagram of a communication device according to Embodiment 1 and modifications thereof.
[Fig. 3] Fig. 3 is a circuit diagram of a pre-regulator circuit, a switched-capacitor circuit, an output switching circuit, and a filter circuit according to Embodiment 1.
[Fig. 4] Fig. 4 is a circuit diagram of a digital control circuit according to Embodiment 1.
[Fig. 5] Fig. 5 is a flowchart illustrating a tracking method according to Embodiment 1.
[Fig. 6] Fig. 6 is a plan view of a tracker module according to Embodiment 1.
[Fig. 7] Fig. 7 is a plan view of the tracker module according to Embodiment 1.
[Fig. 8] Fig. 8 is a cross-sectional view of the tracker module according to Embodiment 1.
[Fig. 9] Fig. 9 is a partial circuit diagram of a tracker circuit according to Modification 1 of Embodiment 1.
[Fig. 10] Fig. 10 is a partial circuit diagram of a tracker circuit according to Modification 2 of Embodiment 1.
[Fig. 11] Fig. 11 is a circuit diagram of a communication device according to Embodiment 2.
[Fig. 12] Fig. 12 is a partial circuit diagram of a tracker circuit according to Embodiment 2.
[Fig. 13] Fig. 13 is a partial circuit diagram of a tracker circuit according to another embodiment. Description of Embodiments

### (Circumstances Leading to Present Invention)

In a case where a power amplifier receives supply of a plurality of discrete voltages, noise increases due to discrete changes in voltage level. The increase in noise is particularly pronounced when a mode such as a digital ET mode is used, which is a mode involving rapid discrete changes in voltage level.

In particular, the inventors have found the following issue: when the power supply voltage has large noise, spurious emissions increase due to intermodulation distortion (IMD) (e.g., distortion components resulting from the addition of the frequency of the noise to the frequency of the radio frequency signal), leading to degradation of an adjacent channel power ratio / adjacent channel leakage ratio (ACPR/ACLR).

Inserting a filter circuit for attenuating such spurious emissions into a voltage supply path may lead to increased size of the tracker circuit. This problem becomes particularly pronounced if the tracker circuit is to supply voltages to a plurality of power amplifiers.

Accordingly, a detailed description will be given below, based on embodiments, of a tracker circuit and a tracking method that make it possible to reduce distortion of a radio frequency signal amplified by using a plurality of discrete voltages, and also reduce an increase in the size of the tracker circuit. Embodiments described below each represent generic or specific examples. Features presented in the following embodiments, such as numerical values, shapes, materials, constituent elements, and the positioning and connection of constituent elements, are illustrative only and not intended to be limiting of the present invention.

The drawings are schematic in nature with emphases, omissions, or proportion adjustments made as necessary to illustrate the present disclosure, and do not necessarily represent exact details. Accordingly, the illustrated shapes, positional relationships, and proportions may differ from the actuality. Throughout the drawings, identical reference signs are used to designate substantially identical features, and repetitive description will be sometimes omitted or simplified.

In the figures described below, the x-axis and the y-axis are orthogonal to each other in a plane parallel to a major face of a module laminate. Specifically, if the module laminate has a rectangular shape in plan view, the x-axis is parallel to a first side of the module laminate, and the y-axis is parallel to a second side orthogonal to the first side of the module laminate. A z-axis is an axis perpendicular to the major face of the module laminate. The z-axis has a positive direction defined as an upward direction, and a negative direction defined as a downward direction.

As used in the following description of circuit configurations according to the present invention, expressions such as "connected" mean not only that circuit elements are directly connected by a connection terminal and/or a wiring conductor, but also that circuit elements are electrically connected with another circuit element interposed therebetween. Expressions such as "directly connected" mean that circuit elements are directly connected by a connection terminal and/or a wiring conductor with no other circuit element interposed therebetween. Expressions such as "connected between A and B" mean being positioned between A and B and connected to both A and B, and mean being connected in series with a path located between A and B. Expressions such as "path located between A and B" mean a path formed by a conductor that electrically connects A to B. Expressions such as "connected in series with a path" mean being connected in series with the path, and mean being connected between one end of the path and the other end of the path. Expressions such as "connected in shunt with a path" mean being connected between the path and ground.

As used herein with regard to the positioning of components according to the present invention, expressions such as "a component is disposed at a substrate" include that the component is disposed on a major face of the substrate, and that the component is disposed in the substrate. Expressions such as "a component is disposed on a major face of a substrate" include not only that the component is disposed in contact with the major face of the substrate, but also that the component is disposed above the major face without making contact with the major face (e.g., the component is stacked on another component disposed in contact with the major face). The expressions such as "a component is disposed on a major face of a substrate" may also include that the component is disposed in a recess defined in the major face. Expressions such as "a component is disposed in a substrate" include, in addition to the meaning that the component is encapsulated in the module laminate, the following meanings: the entirety of the component is disposed between opposite major faces of the substrate but part of the component is not covered by the substrate; and only part of the component is disposed in the substrate.

As used herein with regard to the positioning of components according to the present invention, expressions such as "plan view of a module laminate" mean that an object is orthogonally projected onto an xy-plane and viewed from the positive side of the z-axis. Expressions such as "A overlaps B in plan view" mean that at least part of the region of A orthogonally projected onto the xy-plane overlaps at least part of the region of B orthogonally projected onto the xy-plane. Expressions such as "A is disposed between B and C" mean that at least one of line segments each connecting a given point in B and a given point in C passes through A.

As used herein with regard to the positioning of components according to the present invention, expression such as "A is disposed adjacent to B" indicate that A and B are disposed in proximity to each other. Specifically, such expressions mean that no other circuit component exists in a space where A faces B. In other words, the expressions such as "A is disposed adjacent to B" mean that none of a plurality of line segments each extending from a given point on a surface of A facing B to B in the direction normal to the surface passes through a circuit component other than A and B. In this regard, a circuit component means a component including an active element and/or a passive element. That is, examples of such circuit components include active components such as transistors or diodes, and passive components such as inductors, transformers, capacitors, or resistors, but do not include electromechanical components such as terminals, connectors, or wiring lines.

As used in the present invention, expressions such as "terminal" mean a point where a conductor within an element terminates. If the impedance of a conductor located between elements is sufficiently low, a terminal is interpreted not only as a single point, but also as any given point on the conductor located between the elements or as the entire conductor.

Further, "parallel", "perpendicular", or other such expressions indicative of the relationship between elements, and "rectangular" or other such expressions indicative of a shape of an element, as well as numerical ranges are not intended to represent only their strict meanings but are meant to also include their substantial equivalents, for example, equivalents with deviations or differences of about several percent.

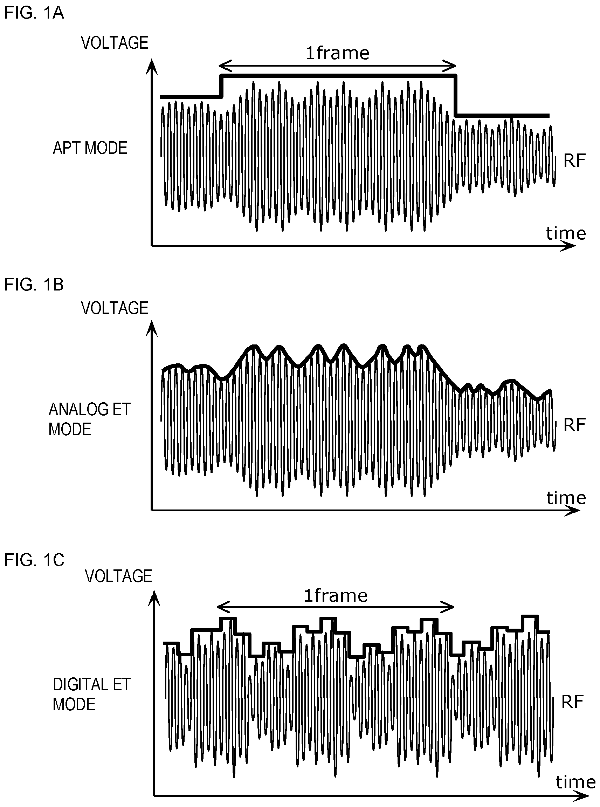

First, as a technique for efficiently amplifying a radio frequency signal, a tracking mode is described below in which a power amplifier receives a power supply voltage that is dynamically adjusted with the passage of time based on the radio frequency signal. A tracking mode refers to a mode that dynamically adjusts the power supply voltage to be applied to a power amplifier. Several types of tracking modes exist, of which APT and ET modes (including an analog ET mode and a digital ET mode) will now be described with reference to Figs. 1A to 1C. In Figs. 1A to 1C, the horizontal axis represents time, and the vertical axis represents voltage. A thick solid line represents power supply voltage, and a thin solid line (waveform) represents modulated signal.

Fig. 1A is a graph illustrating an example of the progression of power supply voltage in the APT mode. In the APT mode, the power supply voltage is varied across a plurality of discrete voltage levels in units of one frame based on average power.

A frame means a unit constituting a radio frequency signal (modulated signal). For example, in 5th Generation New Radio (5GNR) and Long Term Evolution (LTE), a frame includes ten subframes. Each subframe includes a plurality of slots. Each slot includes a plurality of symbols. A subframe has a length of 1 ms, and a frame has a length of 10 ms.

A mode in which the voltage level is varied in units of one frame or in larger units based on average power is referred to as APT mode, which is distinguished from a mode in which the voltage level is varied in units smaller than one frame (e.g., in units of subframes, slots, or symbols). For example, a mode in which the voltage level is varied in units of symbols is referred to as symbol power tracking (SPT) mode, which is distinguished from the APT mode.

Fig. 1B is a graph illustrating an example of the progression of power supply voltage in the analog ET mode. In the analog ET mode, the power supply voltage is varied continuously based on an envelope signal to thereby track the envelope of a modulated signal.

An envelope signal is a signal representing the envelope of a modulated signal. An envelope value is expressed as, for example, the square root of (I² + Q²). In this case, (I, Q) represents a constellation point. A constellation point is a point representing, on a constellation diagram, a signal modulated by digital modulation. (I, Q) is determined by, for example, a baseband integrated circuit (BBIC) based on, for example, transmission information.

Fig. 1C is a graph illustrating an example of the progression of power supply voltage in the digital ET mode. In the digital ET mode, the power supply voltage is varied across a plurality of discrete voltage levels within one frame based on an envelope signal to thereby track the envelope of a modulated signal.

### (Embodiment 1)

Embodiment 1 will now be described. A communication device 7A according to Embodiment 1 corresponds to user equipment (UE) in a cellular network. Typical examples of the communication device 7A include a mobile phone, a smartphone, a tablet computer, and a wearable device. The communication device 7A may be an Internet of Things (IoT) sensor device, a medical/healthcare device, a vehicle, an unmanned aerial vehicle (UAV) (a so-called drone), or an automated guided vehicle (AGV). The communication device 7A may also function as a base station (BS) in a cellular network.

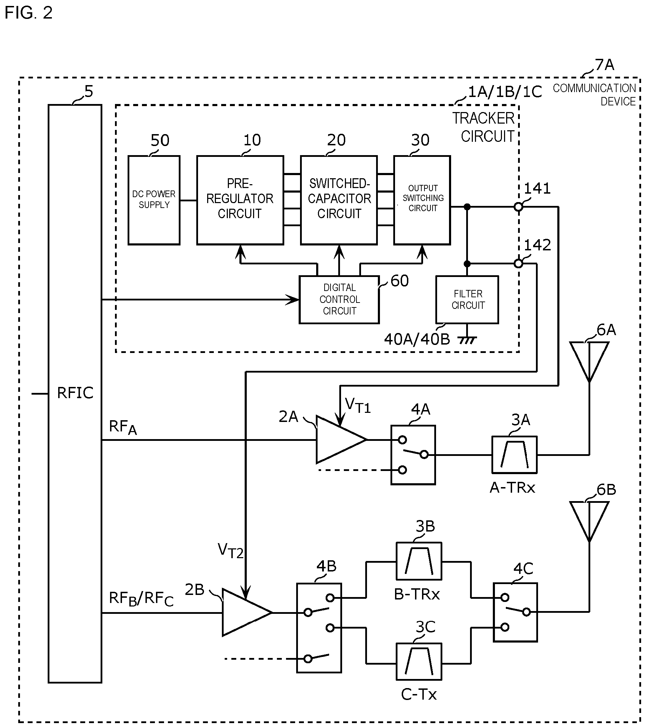

The circuit configuration of each of the communication device 7A and a tracker circuit 1A according to Embodiment 1 will now be described with reference to Fig. 2. Fig. 2 is a circuit diagram of the communication device 7A according to Embodiment 1 and modifications thereof.

Fig. 2 illustrates an exemplary circuit configuration. The communication device 7A and the tracker circuit 1A may be implemented by using any one of a wide variety of circuit implementations and circuit technologies. Therefore, the description of the communication device 7A and the tracker circuit 1A provided below is not to be construed restrictively.

### [1.1 Circuit Configuration of Communication Device 7A]

First, the communication device 7A according to Embodiment 1 will be described with reference to Fig. 2. The communication device 7A includes the tracker circuit 1A, power amplifiers 2A and 2B, filters 3A to 3C, switches 4A to 4C, a radio frequency integrated circuit (RFIC) 5, and antennas 6A and 6B.

The tracker circuit 1A is capable of, based on a tracking mode, supplying a plurality of discrete voltages V_{T1} to the power amplifier 2A, and supplying a plurality of discrete voltages V_{T2} to the power amplifier 2B. The tracking mode used may be, but is not limited to, the digital ET mode or the SPT mode.

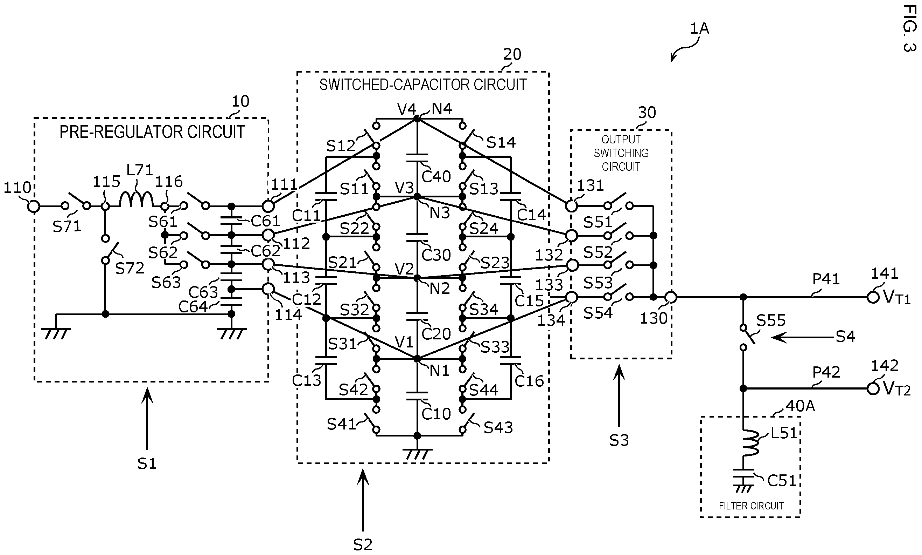

As illustrated in Fig. 2, the tracker circuit 1A includes a pre-regulator circuit 10, a switched-capacitor circuit 20, an output switching circuit 30, a filter circuit 40A, a direct current (DC) power supply 50, a digital control circuit 60, external connection terminals 141 and 142, and a switch S55 (see Fig. 3).

The external connection terminal 141 is an example of a first external connection terminal. The external connection terminal 141 is connected at a location outside the tracker circuit 1A to the power amplifier 2A, and connected at a location inside the tracker circuit 1A to the output switching circuit 30 via a voltage supply path P41.

The external connection terminal 142 is an example of a second external connection terminal. The external connection terminal 142 is connected at a location outside the tracker circuit 1A to the power amplifier 2B, and connected at a location inside the tracker circuit 1A to the output switching circuit 30 via a voltage supply path P42.

The voltage supply path P41 is an example of a first voltage supply path. The voltage supply path P41 is part of a path connecting the output switching circuit 30 and the power amplifier 2A. In this case, the voltage supply path P41 is a path directly connecting the output switching circuit 30 and the external connection terminal 141. That is, according to Embodiment 1, no circuit element (e.g., an active element and a passive element) is connected in series with the voltage supply path P41. Alternatively, the connection between the output switching circuit 30 and the external connection terminal 141 may be a non-direct connection. That is, a circuit element may be connected in series with the voltage supply path P41.

The voltage supply path P42 is an example of a second voltage supply path. The voltage supply path P42 is part of a path connecting the output switching circuit 30 and the power amplifier 2B. In this case, the voltage supply path P42 serves to connect the output switching circuit 30 and the external connection terminal 142, and partially overlaps the voltage supply path P41. Alternatively, the voltage supply path P42 may be entirely non-overlapping with the voltage supply path P41.

The pre-regulator circuit 10 includes a power inductor, and a switch. A power inductor is an inductor used to step up and/or step down a DC voltage. The power inductor is connected in series with a DC path. The power inductor may be connected (disposed in parallel) between the DC path and ground. The pre-regulator circuit 10 is capable of converting an input voltage into a first voltage by using the power inductor. Such a pre-regulator circuit 10 may be referred to also as magnetic regulator or DC-DC converter.

The switched-capacitor circuit 20 includes a plurality of capacitors, and a plurality of switches. The switched-capacitor circuit 20 is capable of receiving the first voltage from the pre-regulator circuit 10, and generating, from the first voltage, a plurality of second voltages as a plurality of discrete voltages each having a corresponding one of a plurality of discrete voltage levels. The switched-capacitor circuit 20 may be referred to also as switched-capacitor voltage ladder.

The output switching circuit 30 is configured to select at least one voltage from among the second voltages generated by the switched-capacitor circuit 20, and output the selected voltage to the power amplifier 2A to thereby modulate the power supply voltage. At this time, the voltage is supplied to the power amplifier 2A via the voltage supply path P41. The output switching circuit 30 is controlled based on a digital control signal. The output switching circuit 30 may be referred to also as supply modulator circuit.

The filter circuit 40A is an example of a first filter circuit, and is a pulse shaping network. The filter circuit 40A is configured to be connectable in shunt with the voltage supply paths P41 and P42. The filter circuit 40A is capable of attenuating noise components of signals (a plurality of discrete voltages) transmitted through the voltage supply paths P41 and P42.

The DC power supply 50 is capable of supplying a DC voltage to the pre-regulator circuit 10. A suitable nonlimiting example of the DC power supply 50 is a rechargeable battery.

The digital control circuit 60 is capable of controlling the following components based on a digital control signal provided from the RFIC 5: the pre-regulator circuit 10, the switched-capacitor circuit 20, the output switching circuit 30, and the filter circuit 40A.

The tracker circuit 1A may be configured not to include at least one of the following components: the pre-regulator circuit 10, the switched-capacitor circuit 20, the output switching circuit 30, the filter circuit 40A, the DC power supply 50, and the digital control circuit 60. In one example, the tracker circuit 1A may be configured not to include the DC power supply 50. In another example, any combination of the pre-regulator circuit 10, the switched-capacitor circuit 20, the output switching circuit 30, and the filter circuit 40A may be integrated into a single circuit. In another example, the tracker circuit 1A may include a plurality of voltage supply circuits as with the configuration described in Patent Document 2, instead of the pre-regulator circuit 10 and the switched-capacitor circuit 20. In this case, the output switching circuit 30 may be configured to select at least one of the voltage supply circuits.

The power amplifier 2A is an example of a first power amplifier. The power amplifier 2A is connected between the RFIC 5 and the filter 3A. Further, the power amplifier 2A is connected to the tracker circuit 1A. The power amplifier 2A is capable of amplifying, by using the discrete voltages V_{T1} received from the tracker circuit 1A, a radio frequency signal RF_{A} (an example of a first radio frequency signal) of Band A received from the RFIC 5.

The power amplifier 2B is an example of a second power amplifier. The power amplifier 2B is connected between the RFIC 5 and the filters 3B and 3C. Further, the power amplifier 2B is connected to the tracker circuit 1A. The power amplifier 2B is capable of amplifying, by using the discrete voltages V_{T2} received from the tracker circuit 1A, the following signals received from the RFIC 5: a radio frequency signal RF_{B} (an example of a second radio frequency signal) of Band B; and a radio frequency signal RF_{C} (an example of a second radio frequency signal) of Band C.

The filter 3A is connected between the power amplifier 2A and the antenna 6A. The filter 3A is a band pass filter with a passband that includes Band A.

The filter 3B is connected between the power amplifier 2B and the antenna 6B. The filter 3B is a band pass filter with a passband that includes Band B.

The filter 3C is connected between the power amplifier 2B and the antenna 6B. The filter 3C is a band pass filter with a passband that includes the transmission band of Band C.

Bands A to C are frequency bands for communication systems built by using radio access technology (RAT). Bands A to C are predefined by standardizing bodies or other entities (e.g., 3rd Generation Partnership Project (3GPP) (registered trademark) and Institute of Electrical and Electronics Engineers (IEEE)). Examples of such communication systems include 5th Generation New Radio (5GNR) systems, Long Term Evolution (LTE) systems, and Wireless Local Area Network (WLAN) systems.

Band A is an example of a first band. According to Embodiment 1, Band A is a frequency band to which time division duplex (TDD) is applied (i.e., a TDD band). Alternatively, Band A may be a frequency band to which frequency division duplex (FDD) is applied (i.e., an FDD band). In this case, the switch 4A need not necessarily be included in the communication device 7A. Each of Bands B and C are an example of a second band. Band B is a TDD band, and Band C is an FDD band.

According to Embodiment 1, Band A is included in an ultra-high band group (3300 to 5000 MHz), and Bands B and C are included in a mid-high band group (1427 to 2690 MHz). Bands A to C are not limited to frequency bands included in the ultra-high band group or the mid-high band group. For example, Bands A to C may be included in the same band group.

The switch 4A includes a terminal connected to the filter 3A, a terminal connected to the output terminal of the power amplifier 2A, and a terminal connected to an input terminal of a low-noise amplifier (not illustrated). The switch 4A is capable of switching between connecting the filter 3A to the power amplifier 2A and connecting the filter 3A to the low-noise amplifier.

The switch 4B includes a terminal connected to the output terminal of the power amplifier 2B, a terminal connected to one end of the filter 3B, and a terminal connected to one end of the filter 3C. Further, as required, the switch 4B includes a terminal connected to the input terminal of a low-noise amplifier (not illustrated). The switch 4B is capable of switching between connecting the power amplifier 2B to the filter 3B and connecting the power amplifier 2B to the filter 3C. Further, the switch 4B may be capable of switching between connecting the filter 3B to the power amplifier 2B and connecting the filter 3B to the low-noise amplifier.

The switch 4C includes a terminal connected to the antenna 6B, a terminal connected to the other end of the filter 3B, and a terminal connected to the other end of the filter 3C. The switch 4C is capable of switching between connecting the antenna 6B to the filter 3B and connecting the antenna 6B to the filter 3C.

The RFIC 5 is an example of a signal processing circuit that processes a radio frequency signal. Specifically, the RFIC 5 performs signal processing such as up-conversion on an input transmission signal to thereby generate a radio frequency transmission signal, and supplies the radio frequency transmission signal to the power amplifiers 2A and 2B. The RFIC 5 has a control unit that controls the tracker circuit 1A. The function of the RFIC 5 as a control unit may in part or in whole be implemented outside the RFIC 5.

The antenna 6A outputs a transmission signal of Band A received from the power amplifier 2A via the filter 3A. The antenna 6A need not necessarily be included in the communication device 7A.

The antenna 6B outputs transmission signals of Bands B and C received from the power amplifier 2B via the filters 3B and 3C. The antenna 6B need not necessarily be included in the communication device 7A.

The circuit configuration of the communication device 7A illustrated in Fig. 2 is illustrative and not intended to be limiting. For example, the communication device 7A may include a baseband signal processing circuit that performs signal processing by using an intermediate frequency band lower in frequency than the radio frequency signal RF_{A}. The communication device 7A may include a filter with a passband that includes the reception band of Band **C.** In this case, the filter may be implemented as a duplexer together with the filter 3C. One of the filters 3B and 3C need not necessarily be included in the communication device 7A. In this case, the switch 4B and/or the switch 4C need not necessarily be included in the communication device 7A.

### [1.2 Circuit Configuration of Tracker Circuit 1A]

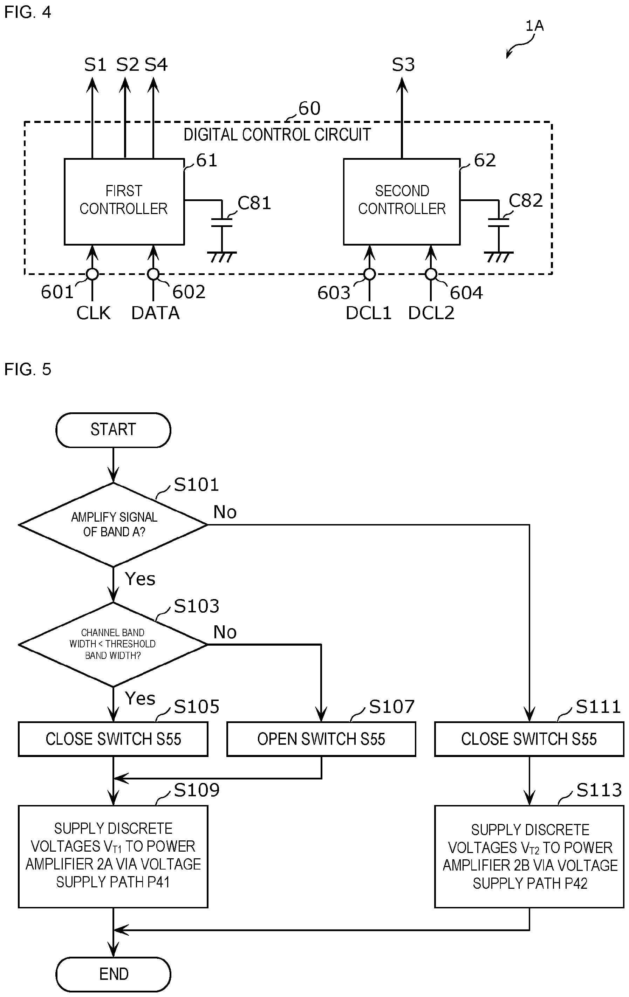

Now, with reference to Figs. 3 and 4, the circuit configuration of each of the following components included in the tracker circuit 1A will be described: the pre-regulator circuit 10, the switched-capacitor circuit 20, the output switching circuit 30, the filter circuit 40A, and the digital control circuit 60. Fig. 3 is a circuit diagram of the following components according to Embodiment 1: the pre-regulator circuit 10, the switched-capacitor circuit 20, the output switching circuit 30, and the filter circuit 40A. Fig. 4 is a circuit diagram of the digital control circuit 60 according to Embodiment 1.

Figs. 3 and 4 illustrate exemplary circuit configurations. The pre-regulator circuit 10, the switched-capacitor circuit 20, the output switching circuit 30, the filter circuit 40A, and the digital control circuit 60 may be implemented by using any one of a wide variety of circuit implementations and circuit technologies. Therefore, the description of each circuit provided below is not to be construed restrictively.

### [1.2.1 Circuit Configuration of Switched-Capacitor Circuit 20]

First, the circuit configuration of the switched-capacitor circuit 20 is described. As illustrated in Fig. 3, the switched-capacitor circuit 20 includes capacitors C11 to C16, capacitors C10, C20, C30 and C40, and switches S11 to S14, S21 to S24, S31 to S34, and S41 to S44. Energy and charge are input, at nodes N1 to N4, from the pre-regulator circuit 10 to the switched-capacitor circuit 20, and output, at the nodes N1 to N4, from the switched-capacitor circuit 20 to the output switching circuit 30.

Each of the capacitors C11 to C16 functions as a flying capacitor (sometimes also referred to as transfer capacitor). That is, each of the capacitors C11 to C16 is used to step up or step down the first voltage supplied from the pre-regulator circuit 10. More specifically, the capacitors C11 to C16 transfer charge between the capacitors C11 to C16 and the nodes N1 to N4 so that voltages V1 to V4 (relative to the ground potential) that satisfy V1:V2:V3:V4 = 1:2:3:4 are maintained at the four nodes N1 to N4. The voltages V1 to V4 correspond to the second voltages each having a corresponding one of a plurality of discrete voltage levels.

The capacitor C11 has two electrodes. One of the two electrodes of the capacitor C11 is connected to one terminal of the switch S11 and one terminal of the switch S12. The other of the two electrodes of the capacitor C11 is connected to one terminal of the switch S21 and one terminal of the switch S22.

The capacitor C12 has two electrodes. One of the two electrodes of the capacitor C12 is connected to the one terminal of the switch S21 and the one terminal of the switch S22. The other of the two electrodes of the capacitor C12 is connected to one terminal of the switch S31 and one terminal of the switch S32.

The capacitor C13 has two electrodes. One of the two electrodes of the capacitor C13 is connected to the one terminal of the switch S31 and the one terminal of the switch S32. The other of the two electrodes of the capacitor C13 is connected to one terminal of the switch S41 and one terminal of the switch S42.

The capacitor C14 has two electrodes. One of the two electrodes of the capacitor C14 is connected to one terminal of the switch S13 and one terminal of the switch S14. The other of the two electrodes of the capacitor C14 is connected to one terminal of the switch S23 and one terminal of the switch S24.

The capacitor C15 has two electrodes. One of the two electrodes of the capacitor C15 is connected to the one terminal of the switch S23 and the one terminal of the switch S24. The other of the two electrodes of the capacitor C15 is connected to one terminal of the switch S33 and one terminal of the switch S34.

The capacitor C16 has two electrodes. One of the two electrodes of the capacitor C16 is connected to the one terminal of the switch S33 and the one terminal of the switch S34. The other of the two electrodes of the capacitor C16 is connected to one terminal of the switch S43 and one terminal of the switch S44.

A set of the capacitors C11 and C14, a set of the capacitors C12 and C15, and a set of the capacitors C13 and C16 are each capable of being charged and discharged in a complementary manner as a first phase and a second phase are repeated.

Specifically, in the first phase, the switches S12, S13, S22, S23, S32, S33, S42, and S43 are turned ON. As a result, for example, one of the two electrodes of the capacitor C12 is connected to the node N3, the other of the two electrodes of the capacitor C12 and the one of the two electrodes of the capacitor C15 are connected to the node N2, and the other of the two electrodes of the capacitor C15 is connected to the node N1.

In the second phase, the switches S11, S14, S21, S24, S31, S34, S41, and S44 are turned ON. As a result, for example, the one of the two electrodes of the capacitor C15 is connected to the node N3, the other of the two electrodes of the capacitor C15 and the one of the two electrodes of the capacitor C12 are connected to the node N2, and the other of the two electrodes of the capacitor C12 is connected to the node N1.

The first phase and the second phase are repeated as described above. Consequently, for example, when one of the capacitors C12 and C15 is being charged from the node N2, the other of the capacitors C12 and C15 can be discharged to the capacitor C30. That is, the capacitors C12 and C15 are capable of being charged and discharged in a complementary manner.

Likewise, as with the set of the capacitors C12 and C15, the set of the capacitors C11 and C14 and the set of the capacitors C13 and C16 are each capable of being charged and discharged in a complementary manner as the first phase and the second phases are repeated.

Each of the capacitors C10, C20, C30, and C40 functions as a smoothing capacitor. That is, the capacitors C10, C20, C30 and C40 are respectively used to hold and smooth the voltages V1 to V4 at the nodes N1 to N4.

The capacitor C10 is connected between the node N1 and ground. Specifically, one of two electrodes of the capacitor C10 is connected to the node N1. The other of the two electrodes of the capacitor C10 is connected to ground.

The capacitor C20 is connected between the nodes N2 and N1. Specifically, one of two electrodes of the capacitor C20 is connected to the node N2. The other of the two electrodes of the capacitor C20 is connected to the node N1.

The capacitor C30 is connected between the nodes N3 and N2. Specifically, one of two electrodes of the capacitor C30 is connected to the node N3. The other of the two electrodes of the capacitor C30 is connected to the node N2.

The capacitor C40 is connected between the nodes N4 and N3. Specifically, one of two electrodes of the capacitor C40 is connected to the node N4. The other of the two electrodes of the capacitor C40 is connected to the node N3.

The switch S11 is connected between the one of the two electrodes of the capacitor C11 and the node N3. Specifically, the one terminal of the switch S11 is connected to the one of the two electrodes of the capacitor C11. The other terminal of the switch S11 is connected to the node N3.

The switch S12 is connected between the one of the two electrodes of the capacitor C11 and the node N4. Specifically, the one terminal of the switch S12 is connected to the one of the two electrodes of the capacitor C11. The other terminal of the switch S12 is connected to the node N4.

The switch S21 is connected between the one of the two electrodes of the capacitor C12 and the node N2. Specifically, the one terminal of the switch S21 is connected to the one of the two electrodes of the capacitor C12 and the other of the two electrodes of the capacitor C11. The other terminal of the switch S21 is connected to the node N2.

The switch S22 is connected between the one of the two electrodes of the capacitor C12 and the node N3. Specifically, the one terminal of the switch S22 is connected to the one of the two electrodes of the capacitor C12 and the other of the two electrodes of the capacitor C11. The other terminal of the switch S22 is connected to the node N3.

The switch S31 is connected between the other of the two electrodes of the capacitor C12 and the node N1. Specifically, the one terminal of the switch S31 is connected to the other of the two electrodes of the capacitor C12 and the one of the two electrodes of the capacitor C13. The other terminal of the switch S31 is connected to the node N1.

The switch S32 is connected between the other of the two electrodes of the capacitor C12 and the node N2. Specifically, the one terminal of the switch S32 is connected to the other of the two electrodes of the capacitor C12 and the one of the two electrodes of the capacitor C13. The other terminal of the switch S32 is connected to the node N2. That is, the other terminal of the switch S32 is connected to the other terminal of the switch S21.

The switch S41 is connected between the other of the two electrodes of the capacitor C13 and ground. Specifically, the one terminal of the switch S41 is connected to the other of the two electrodes of the capacitor C13. The other terminal of the switch S41 is connected to ground.

The switch S42 is connected between the other of the two electrodes of the capacitor C13 and the node N1. Specifically, the one terminal of the switch S42 is connected to the other of the two electrodes of the capacitor C13. The other terminal of the switch S42 is connected to the node N1. That is, the other terminal of the switch S42 is connected to the other terminal of the switch S31.

The switch S13 is connected between the one of the two electrodes of the capacitor C14 and the node N3. Specifically, the one terminal of the switch S13 is connected to the one of the two electrodes of the capacitor C14. The other terminal of the switch S13 is connected to the node N3. That is, the other terminal of the switch S13 is connected to the other terminal of the switch S11 and the other terminal of the switch S22.

The switch S14 is connected between the one of the two electrodes of the capacitor C14 and the node N4. Specifically, the one terminal of the switch S14 is connected to the one of the two electrodes of the capacitor C14. The other terminal of the switch S14 is connected to the node N4. That is, the other terminal of the switch S14 is connected to the other terminal of the switch S12.

The switch S23 is connected between the one of the two electrodes of the capacitor C15 and the node N2. Specifically, the one terminal of the switch S23 is connected to one of the two electrodes of the capacitor C15 and the other of the two electrodes of the capacitor C14. The other terminal of the switch S23 is connected to the node N2. That is, the other terminal of the switch S23 is connected to the other terminal of the switch S21 and the other terminal of the switch S32.

The switch S24 is connected between the one of the two electrodes of the capacitor C15 and the node N3. Specifically, the one terminal of the switch S24 is connected to the one of the two electrodes of the capacitor C15 and the other of the two electrodes of the capacitor C14. The other terminal of the switch S24 is connected to the node N3. That is, the other terminal of the switch S24 is connected to the other terminal of the switch S11, the other terminal of the switch S22, and the other terminal of the switch S13.

The switch S33 is connected between the other of the two electrodes of the capacitor C15 and the node N1. Specifically, the one terminal of the switch S33 is connected to the other of the two electrodes of the capacitor C15 and the one of the two electrodes of the capacitor C16. The other terminal of the switch S33 is connected to the node N1. That is, the other terminal of the switch S33 is connected to the other terminal of the switch S31 and the other terminal of the switch S42.

The switch S34 is connected between the other of the two electrodes of the capacitor C15 and the node N2. Specifically, the one terminal of the switch S34 is connected to the other of the two electrodes of the capacitor C15 and the one of the two electrodes of the capacitor C16. The other terminal of the switch S34 is connected to the node N2. That is, the other terminal of the switch S34 is connected to the other terminal of the switch S21, the other terminal of the switch S32, and the other terminal of the switch S23.

The switch S43 is connected between the other of the two electrodes of the capacitor C16 and ground. Specifically, the one terminal of the switch S43 is connected to the other of the two electrodes of the capacitor C16. The other terminal of the switch S43 is connected to ground.

The switch S44 is connected between the other of the two electrodes of the capacitor C16 and the node N1. Specifically, the one terminal of the switch S44 is connected to the other of the two electrodes of the capacitor C16. The other terminal of the switch S44 is connected to the node N1. That is, the other terminal of the switch S44 is connected to the other terminal of the switch S31, the other terminal of the switch S42, and the other terminal of the switch S33.

A first set of switches including the switches S12, S13, S22, S23, S32, S33, S42, and S43, and a second set of switches including the switches S11, S14, S21, S24, S31, S34, S41, and S44 are switched between ON and OFF in a complementary manner based on a control signal S2. Specifically, in the first phase, the switches in the first set are turned ON, and the switches in the second set are turned OFF. Conversely, in the second phase, the switches in the first set are turned OFF, and the switches in the second set are turned ON.

For example, in one of the first and second phases, charging of the capacitors C10 to C40 from the capacitors C11 to C13 is executed, and in the other of the first and second phases, charging of the capacitors C10 to C40 from the capacitors C14 to C16 is executed. That is, the capacitors C10 to C40 are constantly charged from the capacitors C11 to C13 or the capacitors C14 to C16. This ensures that even when current flows rapidly from the nodes N1 to N4 to the output switching circuit 30, the nodes N1 to N4 are rapidly replenished with charge. This in turn makes it possible to reduce fluctuations in potential at the nodes N1 to N4.

The operation mentioned above allows a substantially equal voltage to be maintained across each of the capacitors C10, C20, C30, and C40 in the switched-capacitor circuit 20. Specifically, the voltages V1 to V4 (relative to the ground potential) that satisfy V1:V2:V3:V4 = 1:2:3:4 are maintained at the four nodes labeled V1 to V4. The voltage levels of the voltages V1 to V4 correspond to the discrete levels of voltage that can be supplied by the switched-capacitor circuit 20 to the output switching circuit 30.

The voltage ratio V1:V2:V3:V4 is not limited to 1:2:3:4. For example, the voltage ratio V1:V2:V3:V4 may be 1:2:4:8.

The configuration of the switched-capacitor circuit 20 illustrated in Fig. 3 is illustrative and not intended to be limiting. In Fig. 3, the switched-capacitor circuit 20 is configured to be capable of supplying four discrete levels of voltage. This configuration, however, is not intended to be limiting. The switched-capacitor circuit 20 may be configured to be capable of supplying any number of discrete levels of voltage greater than or equal to two. For example, if the switched-capacitor circuit 20 is to supply two discrete levels of voltage, it may suffice that the switched-capacitor circuit 20 includes at least the capacitors C12 and C15 and the switches S21 to S24 and S31 to S34.

### [1.2.2 Circuit Configuration of Output Switching Circuit 30]

The circuit configuration of the output switching circuit 30 will now be described. The output switching circuit 30 is connected to the digital control circuit 60. As illustrated in Fig. 3, the output switching circuit 30 includes input terminals 131 to 134, switches S51 to S54, and an output terminal 130.

The output terminal 130 is connected to the external connection terminal 141. The output terminal 130 is a terminal for supplying a power supply voltage selected from among the voltages V1 to V4 to the power amplifier 2A via the external connection terminal 141.

The input terminals 131 to 134 are respectively connected to the nodes N4 to N1 of the switched-capacitor circuit 20. The input terminals 131 to 134 are terminals for respectively receiving the voltages V4 to V1 from the switched-capacitor circuit 20.

The switch S51 is connected between the input terminal 131 and the output terminal 130. Specifically, the switch S51 has a terminal connected to the input terminal 131, and a terminal connected to the output terminal 130. With the connection arrangement mentioned above, the switch S51 is switched between ON and OFF (close and open states) based on a control signal S3 to allow switching between connection and disconnection of the input terminal 131 and the output terminal 130 to and from each other.

The switch S52 is connected between the input terminal 132 and the output terminal 130. Specifically, the switch S52 has a terminal connected to the input terminal 132, and a terminal connected to the output terminal 130. With the connection arrangement mentioned above, the switch S52 is switched between ON and OFF based on the control signal S3 to allow switching between connection and disconnection of the input terminal 132 and the output terminal 130 to and from each other.

The switch S53 is connected between the input terminal 133 and the output terminal 130. Specifically, the switch S53 has a terminal connected to the input terminal 133, and a terminal connected to the output terminal 130. With the connection arrangement mentioned above, the switch S53 is switched between ON and OFF based on the control signal S3 to allow switching between connection and disconnection of the input terminal 133 and the output terminal 130 to and from each other.

The switch S54 is connected between the input terminal 134 and the output terminal 130. Specifically, the switch S54 has a terminal connected to the input terminal 134, and a terminal connected to the output terminal 130. With the connection arrangement mentioned above, the switch S54 is switched between ON and OFF based on the control signal S3 to allow switching between connection and disconnection of the input terminal 134 and the output terminal 130 to and from each other.

The switches S51 to S54 are controlled to be exclusively ON. That is, only one of the switches S51 to S54 is turned ON, with the remainder of the switches S51 to S54 being turned OFF. This allows the output switching circuit 30 to output one voltage selected from among the voltages V1 to V4.

The configuration of the output switching circuit 30 illustrated in Fig. 3 is illustrative and not intended to be limiting. In particular, the switches S51 to S54 may have any configuration that allow at least one of the four input terminals 131 to 134 to be selectively connected to the output terminal 130. In one alternative example, the output switching circuit 30 may further include a switch connected between a set of the switches S51 to S53, and a set of the switch S54 and the output terminal 130. In another alternative example, the output switching circuit 30 may further include a switch connected between a set of the switches S51 and S52, and a set of the switches S53 and S54 and the output terminal 130.

If two discrete levels of voltage are to be supplied from the switched-capacitor circuit 20, the output switching circuit 30 may simply include at least two of the switches S51 to S54.

### [1.2.3 Circuit Configuration of Pre-Regulator Circuit 10]

First, the configuration of the pre-regulator circuit 10 is described below. As illustrated in Fig. 3, the pre-regulator circuit 10 includes an input terminal 110, output terminals 111 to 114, inductor connection terminals 115 and 116, switches S61 to S63, S71 and S72, a power inductor L71, and capacitors C61 to C64.

The input terminal 110 is an input terminal for a DC voltage. That is, the input terminal 110 is a terminal for receiving an input voltage from the DC power supply 50.

The output terminal 111 is an output terminal for the voltage V4. That is, the output terminal 111 is a terminal for supplying the voltage V4 to the switched-capacitor circuit 20. The output terminal 111 is connected to the node N4 of the switched-capacitor circuit 20.

The output terminal 112 is an output terminal for the voltage V3. That is, the output terminal 112 is a terminal for supplying the voltage V3 to the switched-capacitor circuit 20. The output terminal 112 is connected to the node N3 of the switched-capacitor circuit 20.

The output terminal 113 is an output terminal for the voltage V2. That is, the output terminal 113 is a terminal for supplying the voltage V2 to the switched-capacitor circuit 20. The output terminal 113 is connected to the node N2 of the switched-capacitor circuit 20.

The output terminal 114 is an output terminal for the voltage V1. That is, the output terminal 114 is a terminal for supplying the voltage V1 to the switched-capacitor circuit 20. The output terminal 114 is connected to the node N1 of the switched-capacitor circuit 20.

The inductor connection terminal 115 is connected to one end of the power inductor L71. The inductor connection terminal 116 is connected to the other end of the power inductor L71.

The switch S71 is connected between the input terminal 110, and the one end of the power inductor L71. Specifically, the switch S71 has a terminal connected to the input terminal 110, and a terminal connected to the one end of the power inductor L71 via the inductor connection terminal 115. With the connection arrangement mentioned above, the switch S71 is switched between ON and OFF based on a control signal S1 to allow switching between connection and disconnection of the input terminal 110 and the one end of the power inductor L71 to and from each other.

The switch S72 is connected between the one end of the power inductor L71 and ground. Specifically, the switch S72 has a terminal connected to the one end of the power inductor L71 via the inductor connection terminal 115, and a terminal connected to ground. With the connection arrangement mentioned above, the switch S72 can be switched between ON and OFF based on the control signal S1 to allow switching between connection and disconnection of the one end of the power inductor L71 and ground to and from each other.

The switch S61 is connected between the other end of the power inductor L71 and the output terminal 111. Specifically, the switch S61 has a terminal connected to the other end of the power inductor L71 via the inductor connection terminal 116, and a terminal connected to the output terminal 111. With the connection arrangement mentioned above, the switch S61 can be switched between ON and OFF based on the control signal S1 to allow switching between connection and disconnection of the other one end of the power inductor L71 and the output terminal 111 to and from each other.

The switch S62 is connected between the other end of the power inductor L71 and the output terminal 112. Specifically, the switch S62 has a terminal connected to the other end of the power inductor L71 via the inductor connection terminal 116, and a terminal connected to the output terminal 112. With the connection arrangement mentioned above, the switch S62 can be switched between ON and OFF based on the control signal S1 to allow switching between connection and disconnection of the other one end of the power inductor L71 and the output terminal 112 to and from each other.

The switch S63 is connected between the other end of the power inductor L71 and the output terminal 113. Specifically, the switch S63 has a terminal connected to the other end of the power inductor L71 via the inductor connection terminal 116, and a terminal connected to the output terminal 113. With the connection arrangement mentioned above, the switch S63 can be switched between ON and OFF based on the control signal S1 to allow switching between connection and disconnection of the other one end of the power inductor L71 and the output terminal 113 to and from each other.

One of two electrodes of the capacitor C61 is connected to the switch S61 and the output terminal 111. The other of the two electrodes of the capacitor C61 is connected to the switch S62, the output terminal 112, and one of two electrodes of the capacitor C62.

The one of the two electrodes of the capacitor C62 is connected to the switch S62, the output terminal 112, and the other of the two electrodes of the capacitor C61. The other of the two electrodes of the capacitor C62 is connected to a path that connects the switch S63, the output terminal 113, and one of two electrodes of the capacitor C63.

The one of the two electrodes of the capacitor C63 is connected to the switch S63, the output terminal 113, and the other of the two electrodes of the capacitor C62. The other of the two electrodes of the capacitor C63 is connected to the output terminal 114 and one of two electrodes of the capacitor C64.

The one of the two electrodes of the capacitor C64 is connected to the output terminal 114 and the other of the two electrodes of the capacitor C63. The other of the two electrodes of the capacitor C64 is connected to ground.

The switches S61 to S63 are controlled to be exclusively ON. That is, only one of the switches S61 to S63 is turned ON, with the remainder of the switches S61 to S63 being turned OFF. Turning ON only one of the switches S61 to S63 as described above allows the pre-regulator circuit 10 to vary the supply voltage for the switched-capacitor circuit 20 between voltage levels corresponding to the voltages V2 to V4.

The pre-regulator circuit 10 configured as described above is capable of supplying charge to the switched-capacitor circuit 20 via at least one of the output terminals 111 to 113.

If an input voltage is to be converted into a single first voltage, the pre-regulator circuit 10 may only need to include at least the switches S71 and S72, and the power inductor L71.

### [1.2.4 Circuit Configuration of Filter Circuit 40A]

The circuit configuration of the filter circuit 40A will now be described. The filter circuit 40A is configured to be connectable in shunt with the voltage supply paths P41 and P42. The filter circuit 40A is capable of attenuating noise components of signals (a plurality of discrete voltages) transmitted through the voltage supply paths P41 and P42. The filter circuit 40A may be referred to also as pulse shaping circuit or termination circuit.

As illustrated in Fig. 3, the filter circuit 40A is connected in shunt with the voltage supply path P41 via the switch S55. That is, the filter circuit 40A is connected between the voltage supply path P41 and ground via the switch S55. Further, the filter circuit 40A is connected between the voltage supply path P42 and ground. The filter circuit 40A includes an inductor L51 and a capacitor C51 that are connected in series.

The inductor L51 is an example of a first inductor. The inductor L51 is connected between the switch S55 and the capacitor C51. Specifically, one end of the inductor L51 is connected to the switch S55, and the other end of the inductor L51 is connected to the capacitor C51.

The capacitor C51 is an example of a first capacitor. The capacitor C51 is connected between the inductor L51 and ground. Specifically, one end of the capacitor C51 is connected to the inductor L51, and the other end of the capacitor C51 is connected to ground.

The switch S55 is an example of a first switch. The switch S55 is connected between the output switching circuit 30 and the external connection terminal 142, and connected between the voltage supply path P41 and the filter circuit 40A. Specifically, one terminal of the switch S55 is connected to the voltage supply path P41, and the other terminal of the switch S55 is connected to the inductor L51 and the external connection terminal 142.

The switch S55 connected as described above is switched between ON and OFF based on a control signal S4. Specifically, ON/OFF of the switch S55 is controlled as described below.

(1) In a case where the radio frequency signal RF_{A} is to be amplified by the power amplifier 2A and the radio frequency signals RF_{B} and RF_{C} are not to be amplified by the power amplifier 2B, when the radio frequency signal RF_{A} has a channel band width (i.e., a modulation band width) greater than or equal to a threshold band width, the switch S55 is opened (turned OFF). The inductor L51 and the capacitor C51 are thus disconnected from the voltage supply path P41. At this time, the discrete voltages V_{T1} are supplied to the power amplifier 2A via the external connection terminal 141, but the filter circuit 40A does not function as a band-reject filter (sometimes referred to also as notch filter) with respect to the voltage supply path P41.
(2) In a case where the radio frequency signal RF_{A} is to be amplified by the power amplifier 2A and the radio frequency signals RF_{B} and RF_{C} are not to be amplified by the power amplifier 2B, when the radio frequency signal RF_{A} has a channel band width less than the threshold band width, the switch S55 is closed (turned ON). The inductor L51 and the capacitor C51 are thus connected in shunt with the voltage supply path P41. At this time, the voltages V_{T1} are supplied to the power amplifier 2A via the external connection terminal 141, and the filter circuit 40A functions as a band-reject filter with respect to the voltage supply path P41.
(3) In a case where the radio frequency signal RF_{B} or RF_{C} is to be amplified by the power amplifier 2B and the radio frequency signal RF_{A} is not to be amplified by the power amplifier 2A, the switch S55 is closed, and the inductor L51 and the capacitor C51 are connected in shunt with the voltage supply path P42. At this time, the voltages V_{T2} are supplied to the power amplifier 2B via the external connection terminal 142, and the filter circuit 40A functions as a band-reject filter with respect to the voltage supply path P42.

The threshold band width used in the above-mentioned control of the switch S55 (an example of a first threshold band width) may be experimentally and/or empirically determined in advance (e.g., 100 MHz).

The stopband of the filter circuit 40A depends on the threshold band width. For example, if 50 MHz is used as the threshold band width, and 1.5 is used as a predetermined coefficient, the stopband of the filter circuit 40A includes a frequency (75 MHz) that is equal to the value of the threshold band width (50 MHz) multiplied by the predetermined coefficient (1.5). This allows the filter circuit 40A to reduce noise components at and around 75 MHz in the voltage supply path P41. This in turn makes it possible to reduce IMD between the radio frequency signal RF_{A} and noise (75 MHz component) in the power amplifier 2A, and consequently reduce adjacent channel leakage power (ACP) in the power amplifier 2A. The respective values of the threshold band width and the predetermined coefficient mentioned above are illustrative and not intended to be limiting.

The stopband is defined as a band with an insertion loss of 15 dB or more. Accordingly, the stopband of the filter circuit 40A can be determined by measuring the power loss between the output terminal of the output switching circuit 30 and the external connection terminal 141, and detecting a band in which the measured loss is 15 dB or more.

The configuration of the filter circuit 40A illustrated in Fig. 3 is illustrative and not intended to be limiting. For example, the filter circuit 40A need not necessarily be connected to the voltage supply path P41 via the switch S55. That is, the switch S55 need not necessarily be included in the tracker circuit 1A. Alternatively, for example, the switch S55 may be connected between the voltage supply path P42 and the filter circuit 40A, or between the filter circuit 40A and ground. The filter circuit 40A may be partially or entirely constituted by a parasitic reactance and/or a parasitic resistance. The parasitic reactance includes, for example, the inductance and/or capacitance of a metal trace connecting two nodes. The parasitic resistance includes, for example, the resistance of a metal trace connecting two nodes.

The above-described control of the switch S55 is illustrative and not intended to be limiting. For example, if the power amplifier 2A selectively amplifies one of transmission signals of a plurality of bands, ON/OFF of the switch S55 may be controlled in accordance with the band of the transmission signal to be amplified.

### [1.2.5 Circuit Configuration of Digital Control Circuit 60]

The circuit configuration of the digital control circuit 60 will now be described. As illustrated in Fig. 4, the digital control circuit 60 incudes a first controller 61, a second controller 62, capacitors C81 and C82, and control terminals 601 to 604.

The first controller 61 is capable of generating the control signals S1, S2, and S4 by processing source-synchronous digital control signals received from the RFIC 5 via the control terminals 601 and 602. The control signal S1 is a signal for controlling the ON/OFF of the switches S61 to S63, S71, and S72 included in the pre-regulator circuit 10. The control signal S2 is a signal for controlling the ON/OFF of the switches S11 to S14, S21 to S24, S31 to S34, and S41 to S44 included in the switched-capacitor circuit 20. The control signal S4 is a signal for controlling the ON/OFF of the switch S55. The first controller 61 may receive an input of a feedback signal for controlling the pre-regulator circuit 10.

The digital control signals to be processed by the first controller 61 are not limited to source-synchronous digital control signals. For example, the first controller 61 may process clock-embedded digital control signals. The first controller 61 may generate a control signal for controlling the output switching circuit 30.

According to Embodiment 1, a single set of a clock signal and a data signal is used as digital control signals for controlling the pre-regulator circuit 10, the switched-capacitor circuit 20, and the filter circuit 40A. This configuration, however, is not intended to be limiting. For example, sets of a clock signal and a data signal may be used individually as digital control signals for controlling the pre-regulator circuit 10, the switched-capacitor circuit 20, and the filter circuit 40A.

The second controller 62 generates the control signal S3 by processing digital control level (DCL) signals (DCL1 and DCL2) received from the RFIC 5 via the control terminals 603 and 604. The DCL signals (DCL1 and DCL2) are generated by the RFIC 5 based on, for example, the envelope signal of a radio frequency signal. The control signal S3 is a signal for controlling the ON/OFF of the switches S51 to S54 included in the output switching circuit 30.

The DCL signals (DCL1 and DCL2) are each a 1-bit signal. The voltages V1 to V4 are each represented by a combination of two 1-bit signals. For example, V1, V2, V3, and V4 are represented by "00", "01", "10", and "11", respectively. A gray code may be used to represent a voltage level.

The capacitor C81 is connected between the first controller 61 and ground. For example, the capacitor C81 is connected between ground and a power supply line that supplies power to the first controller 61, and functions as a bypass capacitor. The capacitor C82 is connected between the second controller 62 and ground. The capacitors C81 and C82 need not necessarily be included in the digital control circuit 60.

According to Embodiment 1, two DCL signals are used to control the output switching circuit 30. The number of DCL signals, however, is not limited to two. For example, one DCL signal, or any number of DCL signals greater than or equal to three may be used in accordance with the number of voltage levels selectable by each output switching circuit 30. The digital control signal to be used for controlling the output switching circuit 30 is not limited to a DCL signal.

### [1.3 Tracking Method]

With reference to Fig. 5, a tracking method will now be described, which is a method for supplying a plurality of discrete voltages by the tracker circuit 1A configured as described above. Fig. 5 is a flowchart illustrating a tracking method according to Embodiment 1.

For example, it is determined by the RFIC 5 whether the radio frequency signal RF_{A} of Band A is to be amplified by the power amplifier 2A (S101). If it is determined at this time that the radio frequency signal RF_{A} of Band A is to be amplified by the power amplifier 2A (Yes at S101), it is determined whether the radio frequency signal RF_{A} has a channel band width less than a threshold band width (S103). If it is determined at this time that the radio frequency signal RF_{A} has a channel band width less than the threshold band width (Yes at S103), the digital control circuit 60 receives a digital control signal indicating that the switch S55 is to be closed, and transmits, to the switch S55, the control signal S4 for closing the switch S55. As the switch S55 is closed based on the control signal S4, the filter circuit 40A is connected to the voltage supply path P41 (S105).

If it is determined that the radio frequency signal RF_{A} has a channel band width greater than or equal to the threshold band width (No at S103), the digital control circuit 60 receives a digital control signal indicating that the switch S55 is to be opened, and transmits, to the switch S55, the control signal S4 for opening the switch S55. As the switch S55 is opened based on the control signal S4, the filter circuit 40A is disconnected from the voltage supply path P41 (S107).

With the switch S55 being controlled in this way, the output switching circuit 30 selectively outputs, based on the control signal S3, at least one of a plurality of discrete voltages to the external connection terminal 141 (S109). As a result, at least one of the discrete voltages is selectively supplied to the power amplifier 2A.

If it is determined that the radio frequency signal RF_{A} of Band A is not to be amplified by the power amplifier 2A (No at S101), that is, if it is determined that the radio frequency signal RF_{B} of Band B or the radio frequency signal RF_{C} of Band C is to be amplified by the power amplifier 2B, the digital control circuit 60 receives a digital control signal indicating that the switch S55 is to be closed, and transmits, to the switch S55, the control signal S4 for closing the switch S55. As the switch S55 is closed based on the control signal S4, the output switching circuit 30 is connected to the external connection terminal 142 (i.e., the voltage supply path P42 is connected), and the filter circuit 40A is connected to the voltage supply path P42 (S111).

With the switch S55 being controlled in this way, the output switching circuit 30 selectively outputs, based on the control signal S3, at least one of a plurality of discrete voltages to the external connection terminal 142 (S113). As a result, at least one of the discrete voltages is selectively supplied to the power amplifier 2B.

### [1.4 Implementation Example of Tracker Circuit 1A]

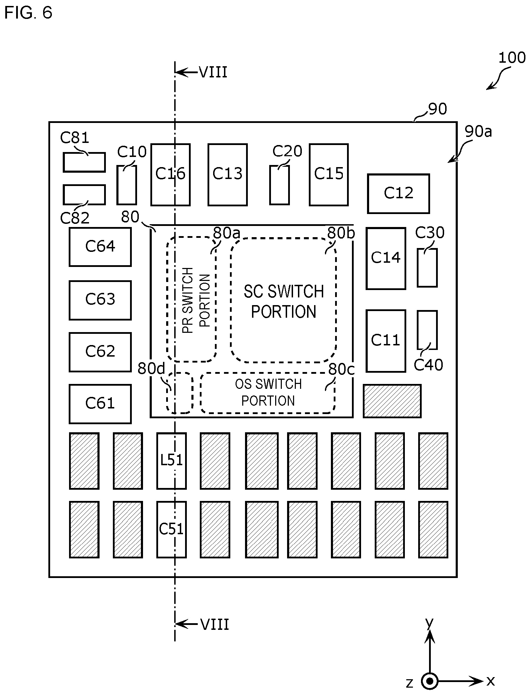

A tracker module 100 will now be described with reference to Figs. 6 to 8 as an implementation example of the tracker circuit 1A configured as described above. According to the implementation example, the power inductor L71 included in the pre-regulator circuit 10 is not disposed at a module laminate 90. This configuration, however, is not intended to be limiting. That is, the power inductor L71 may be disposed at the module laminate 90.

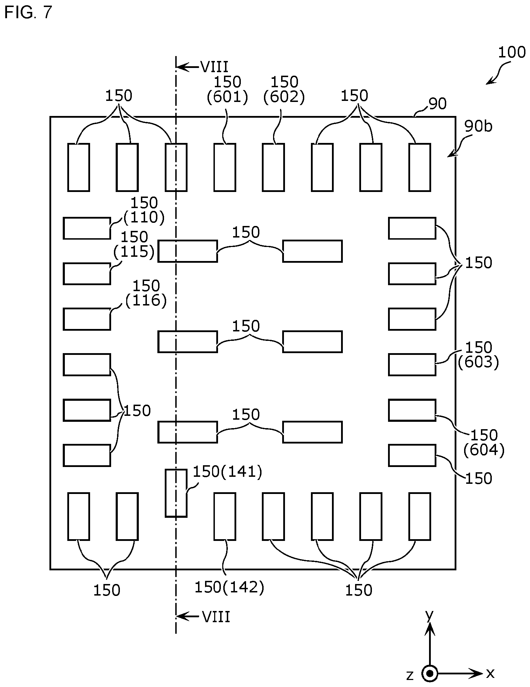

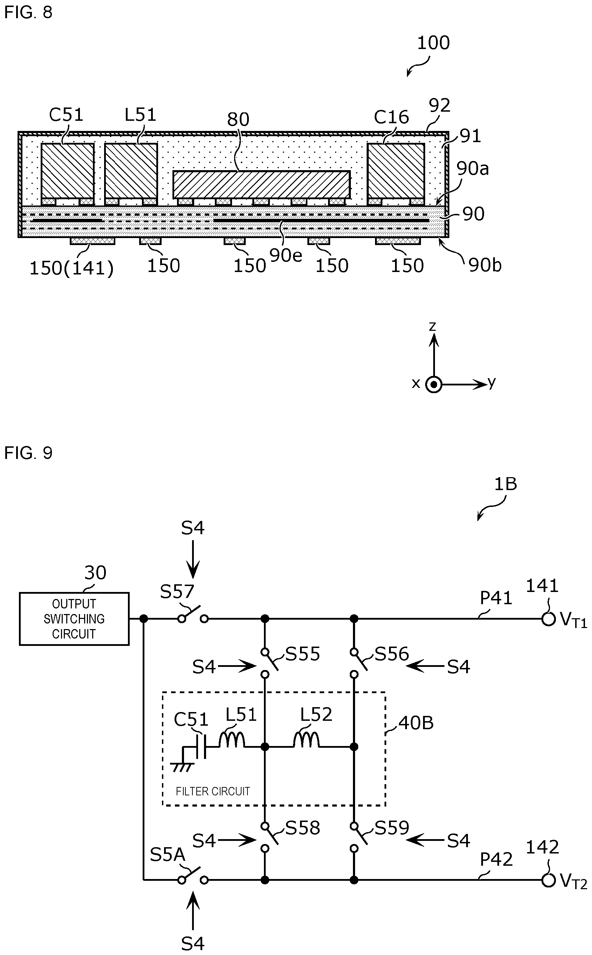

Fig. 6 is a plan view of the tracker module 100 according to Embodiment 1. Fig. 7 is a plan view of the tracker module 100 according to Embodiment 1, with a major face 90b of the module laminate 90 seen through from the positive side of the z-axis. Fig. 8 is a cross-sectional view of the tracker module 100 according to Embodiment 1. The cross-section of the tracker module 100 in Fig. 8 is taken along a line VIII-VIII in each of Figs. 6 and 7.

In Figs. 6 to 8, the illustration of some of wiring lines connecting a plurality of circuit components disposed at the module laminate 90 is omitted. In Figs. 6 and 7, the illustration of a resin member 91 covering the circuit components and a shield electrode layer 92 covering the surface of the resin member 91 is omitted. In Fig. 6, hatched blocks represent optional circuit components that are not essential to the present invention.

The tracker module 100 includes the module laminate 90, the resin member 91, the shield electrode layer 92, and a plurality of electrodes 150, in addition to the circuit components including the active and passive elements that are included in the following circuits illustrated in Figs. 3 and 4: the pre-regulator circuit 10, the switched-capacitor circuit 20, the output switching circuit 30, the filter circuit 40A, and the digital control circuit 60.

The module laminate 90 has opposite major faces 90a and 90b. A ground plane 90e or other components are provided in the module laminate 90 and on the major face 90a. Although the module laminate 90 is depicted in Figs. 6 and 7 as having a rectangular shape in plan view, the shape of the module laminate 90 is not limited to a rectangular shape.

Suitable examples of the module laminate 90 may include, but are not limited to: a low temperature co-fired ceramics (LTCC) substrate or a high temperature co-fired ceramics (HTCC) substrate that has a multilayer structure of a plurality of dielectric layers; a component-embedded substrate; a substrate with a redistribution layer (RDL); and a printed circuit board.

The following components are disposed on the major face 90a: an integrated circuit 80, the capacitors C10 to C16, C20, C30, C40, C51, C61 to C64, C81, and C82, the inductor L51, and the resin member 91.

The integrated circuit 80 includes a PR switch portion 80a, an SC switch portion 80b, an OS switch portion 80c, and a filter switch portion 80d. The PR switch portion 80a includes the switches S61 to S63, S71, and S72. The SC switch portion 80b includes the switches S11 to S14, S21 to S24, S31 to S34, and S41 to S44. The OS switch portion 80c includes the switches S51 to S54. The filter switch portion 80d includes the switch S55.

In Fig. 6, the PR switch portion 80a, the SC switch portion 80b, the OS switch portion 80c, and the filter switch portion 80d are included in the same single integrated circuit 80. This configuration, however, is not intended to be limiting. In one alternative example, the PR switch portion 80a and the SC switch portion 80b may be included in a single integrated circuit, and the OS switch portion 80c and the filter switch portion 80d may be included in another integrated circuit. In another alternative example, the SC switch portion 80b, the OS switch portion 80c, and the filter switch portion 80d may be included in a single integrated circuit, and the PR switch portion 80a may be included in another integrated circuit. In another alternative example, the PR switch portion 80a, the OS switch portion 80c, and the filter switch portion 80d may be included in a single integrated circuit, and the SC switch portion 80b may be included in another integrated circuit. In another alternative example, the PR switch portion 80a, the SC switch portion 80b, the OS switch portion 80c, and the filter switch portion 80d may be individually included in four different integrated circuits. A plurality of integrated circuits can be manufactured by different process technology nodes.

Although the integrated circuit 80 is depicted in Fig. 6 as having a rectangular shape in plan view of the module laminate 90, the shape of the integrated circuit 80 is not limited to a rectangular shape.

The integrated circuit 80 is implemented by using, for example, complementary metal oxide semiconductor (CMOS). Specifically, the integrated circuit 80 may be manufactured by a silicon on insulator (SOI) process. The integrated circuit 80 is not limited to CMOS.

The capacitors C10 to C16, C20, C30, C40, C51, C61 to C64, C81, and C82 are implemented as chip capacitors. A chip capacitor means a surface mount device (SMD) constituting a capacitor. The capacitors need not necessarily be implemented as chip capacitors. For example, a subset or all of the capacitors may be included in an integrated passive device (IPD), or may be included in the integrated circuit 80.

The inductor L51 is implemented as a chip inductor. A chip inductor means an SMD constituting an inductor. The inductor L51 need not necessarily be implemented as a chip capacitor. For example, the inductor L51 may be included in an IPD.

As described above, the capacitors and the inductor disposed on the major face 90a are grouped for each individual circuit and disposed around the integrated circuit 80.

Specifically, a group of the capacitors C61 to C64 included in the pre-regulator circuit 10 is disposed in a region on the major face 90a located between the following two straight lines in plan view of the module laminate 90: a straight line extending along the left side of the integrated circuit 80; and a straight line extending along the left side of the module laminate 90. The group of circuit components included in the pre-regulator circuit 10 is thus disposed near the PR switch portion 80a located within the integrated circuit 80.

A group of the capacitors C10 to C16, C20, C30, and C40 included in the switched-capacitor circuit 20 is disposed in the following two regions on the major face 90a in plan view of the module laminate 90: a region located between a straight line extending along the top side of the integrated circuit 80 and a straight line extending along the top side of the module laminate 90; and a region located between a straight line extending along the right side of the integrated circuit 80 and a straight line extending along the right side of the module laminate 90. The group of circuit components included in the switched-capacitor circuit 20 is thus disposed near the SC switch portion 80b located within the integrated circuit 80. That is, the SC switch portion 80b is disposed closer to the switched-capacitor circuit 20 than is each of the PR switch portion 80a and the OS switch portion 80c.

A group of the capacitor C51 and the inductor L51 included in the filter circuit 40A is disposed in a region on the major face 90a located between the following two lines in plan view of the module laminate 90: a straight line extending along the bottom side of the integrated circuit 80; and a straight line extending along the bottom side of the module laminate 90. The group of circuit components included in the filter circuit 40A is thus disposed near the filter switch portion 80d located within the integrated circuit 80. That is, the filter switch portion 80d is disposed closer to the capacitor C51 and the inductor L51 of the filter circuit 40A than is each of the PR switch portion 80a and the SC switch portion 80b.

The electrodes 150 are disposed on the major face 90b. At least one of the electrodes 150 functions as the external connection terminal 141 illustrated in Fig. 2. The electrodes 150 are electrically connected to the electronic components disposed on the major face 90a via, for example, via-conductors provided in the module laminate 90. The electrodes 150 may be, but are not limited to, copper electrodes. For example, the electrodes may be solder electrodes.

The resin member 91 covers the major face 90a and at least a subset of the electronic components disposed on the major face 90a. The resin member 91 serves to ensure reliability, such as mechanical strength and moisture resistance, of the electronic components disposed on the major face 90a. The resin member 91 need not necessarily be included in the tracker module 100.

The shield electrode layer 92 is an example of a metal layer. The shield electrode layer 92 is a metal thin film formed by, for example, sputtering. The shield electrode layer 92 is provided so as to cover the surface (upper face and lateral faces) of the resin member 91. The shield electrode layer 92 is connected to ground. The shield electrode layer 92 reduces the entry of external noise into the electronic components constituting the tracker module 100, and reduces the interference of noise generated in the tracker module 100 with another module or another device. The shield electrode layer 92 need not necessarily be included in the tracker module 100.

The configuration of the tracker module 100 illustrated in Figs. 6 to 8 is illustrative and not intended to be limiting. For example, as for the capacitors and the inductor disposed on the major face 90a, a subset of these components may be provided in the module laminate 90. In another example, as for the capacitors and the inductor disposed on the major face 90a, a subset of these components need not necessarily be included in the tracker module 100, and need not necessarily be disposed at the module laminate 90.

### [1.5 Advantageous Effects, etc.]

As described above, the tracker circuit 1A according to Embodiment 1 includes the output switching circuit 30 configured to selectively output at least one of a plurality of discrete voltages to the power amplifiers 2A and 2B. The power amplifier 2A is configured to amplify the radio frequency signal RF_{A} of Band A. The power amplifier 2B is configured to amplify the radio frequency signal RF_{B} of Band B. The tracker circuit 1A further includes: the voltage supply path P41 connecting the output switching circuit 30 and the power amplifier 2A; the voltage supply path P42 connecting the output switching circuit 30 and the power amplifier 2B; and the filter circuit 40A connectable in shunt with the voltage supply paths P41 and P42.

In another aspect, the tracker circuit 1A according to Embodiment 1 includes: the external connection terminal 141 connected to the power amplifier 2A; the external connection terminal 142 connected to the power amplifier 2B; the output switching circuit 30 configured to selectively output at least one of a plurality of discrete voltages to the external connection terminals 141 and 142; the voltage supply path P41 connecting the output switching circuit 30 and the external connection terminal 141; the voltage supply path P42 connecting the output switching circuit 30 and the external connection terminal 142; and the filter circuit 40A that is connected between the voltage supply path P41 and ground, and that is connected between the voltage supply path P42 and ground.

According to the configuration mentioned above, the filter circuit 40A is connectable in shunt with the voltage supply paths P41 and P42 of the output switching circuit 30. This makes it possible to reduce noise in the voltage supply paths P41 and P42. This in turn makes it possible to reduce IMD in the power amplifiers 2A and 2B, and consequently reduce spurious emissions to thereby achieve, for example, improved ACPR/ACLR. The filter circuit 40A may be connected not in series but in shunt with the voltage supply paths P41 and P42. This makes it possible to reduce loss in the voltage supply paths P41 and P42, and consequently reduce degradation of the discrete voltages to be supplied to the power amplifiers 2A and 2B. Further, the filter circuit 40A is connectable with both the voltage supply paths P41 and P42. This makes it possible to achieve reduced circuit scale as compared with a case where filter circuits are individually required for the voltage supply paths P41 and P42.

In another example, the tracker circuit 1A according to Embodiment 1 may further include the switch S55 connected between the voltage supply path P41 and the filter circuit 40A. The filter circuit 40A may include the inductor L51 and the capacitor C51 that are connected in series between the switch S55 and ground.

According to the configuration mentioned above, the switch S55 is connected between the voltage supply path P41 and the filter circuit 40A. This makes it possible to switch between connection and disconnection of the filter circuit 40A to and from the voltage supply path P41. This in turn makes it possible to switch between prioritizing reduced noise in the voltage supply path P41, and prioritizing reduced degradation of the discrete voltages in the voltage supply path P41.

In another example, in the tracker circuit 1A according to Embodiment 1, one terminal of the switch S55 may be connected to the output switching circuit 30, and the other terminal of the switch S55 may be connected to the filter circuit 40A and the power amplifier 2B (external connection terminal 142).

According to the configuration mentioned above, the switch S55 is connected in series with the voltage supply path P42. As a result, opening the switch S55 allows the voltage supply path P42 to be disconnected from the voltage supply path P41. This makes it possible to further reduce degradation of the discrete voltages in the voltage supply path P41.

In another example, in the tracker circuit 1A according to Embodiment 1, in a case where the radio frequency signal RF_{A} is to be amplified by the power amplifier 2A, (i) when the radio frequency signal RF_{A} has a channel band width greater than or equal to a first threshold band width, the switch S55 may be opened, and (ii) when the radio frequency signal RF_{A} has a channel band width less than the first threshold band width, the switch S55 may be closed. In a case where the radio frequency signal RF_{B} is to be amplified by the power amplifier 2B, the switch S55 may be closed.

According to the configuration mentioned above, the switch S55 of the filter circuit 40A is closed when the radio frequency signal RF_{A} has a narrow channel band width. When a channel has a narrow band width, the distance (in frequency) from the center frequency of the channel to an adjacent channel is short, and thus the frequencies that cause IMD affecting ACP are low. When a plurality of discrete voltages are to be supplied, noise increases with decreasing frequency in the voltage supply path P41. Consequently, a narrow channel band width results in increased noise at the frequencies that cause IMD affecting ACP. Accordingly, when the channel band width is narrow, the switch S55 is closed. This makes it possible to prioritize reduction of the noise at the frequencies that cause IMD affecting ACP, and thus effectively reduce spurious emissions (i.e., ACP) in the power amplifier 2A. When the radio frequency signal RF_{A} has a wide channel band width, the switch S55 of the filter circuit 40A is opened. When the channel band width is wide, the discrete voltages change rapidly, and thus the voltage supply path P41 is required to have higher responsiveness. Accordingly, when the channel band width is wide, the switch S55 is opened. This makes it possible to reduce degradation of the responsiveness of the voltage supply path P41, and thus effectively reduce degradation of the discrete voltages in the voltage supply path P41.

In the tracker circuit 1A according to Embodiment 1, Band A may be included in the range of 3300 to 5000 MHz, and Band B may be included in the range of 1427 to 2690 MHz.

The configuration mentioned above makes it possible to switch between connection and disconnection of the filter circuit 40A to and from the voltage supply path P41, which is used for Band A with a greater available channel band width and higher in frequency than Band B. As the channel band width increases, the power of a radio frequency signal changes more rapidly, and a plurality of discrete voltages that track the changes in power also change more rapidly. This means that the ability to disconnect the filter circuit 40A from the voltage supply path P41, which is used for Band A with a greater available channel band width and higher in frequency than Band B, results in pronounced reduction of degradation of the discrete voltages.

A tracking method according to Embodiment 1 includes: in a case where the radio frequency signal RF_{A} of Band A is to be amplified by the power amplifier 2A, (i) not connecting the filter circuit 40A to the voltage supply path P41 when the radio frequency signal RF_{A} has a channel band width greater than or equal to a threshold band width, and connecting the filter circuit 40A to the voltage supply path P41 when the radio frequency signal RF_{A} has a channel band width less than the threshold band width, and (ii) selectively supplying at least one of a plurality of discrete voltages to the power amplifier 2A via the voltage supply path P41; and in a case where the radio frequency signal RF_{B} of Band B is to be amplified by the power amplifier 2B, (i) connecting the filter circuit 40A to the voltage supply path P42, and (ii) selectively supplying at least one of a plurality of discrete voltages to the power amplifier 2B via the voltage supply path P42.

The configuration mentioned above allows the filter circuit 40A to be connected to the voltage supply path P41 when the radio frequency signal RF_{A} has a narrow channel band width. When a channel has a narrow band width, the distance (in frequency) from the center frequency of the channel to an adjacent channel is short, and thus the frequencies that cause IMD affecting ACP are low. In this regard, when a plurality of discrete voltages are to be supplied, noise increases with decreasing frequency in the voltage supply path P41. Consequently, a narrow channel band width results in increased noise at the frequencies that cause IMD affecting ACP. Accordingly, when the channel band width is narrow, the filter circuit 40A is connected to the voltage supply path P41. This makes it possible to prioritize reduction of the noise at the frequencies that cause IMD affecting ACP, and thus effectively reduce spurious emissions (i.e., ACP) in the power amplifier 2A. When the radio frequency signal RF_{A} has a wide channel band width, the filter circuit 40A can be disconnected from the voltage supply path P41. When the channel band width is wide, the discrete voltages change rapidly, and thus the voltage supply path P41 is required to have higher responsiveness. Therefore, disconnecting the filter circuit 40A from the voltage supply path P41 when the channel band width is wide makes it possible to reduce degradation of the responsiveness of the voltage supply path P41, and thus effectively reduce degradation of the discrete voltages in the voltage supply path P41.

### (Modification 1 of Embodiment 1)

Modification 1 of Embodiment 1 will now be described. Modification 1 differs from Embodiment 1 mainly in the configuration of the filter circuit. A tracker circuit according to Modification 1 will be described below with reference to the drawings, with focus on differences from Embodiment 1.

### [2.1 Circuit Configuration of Tracker Circuit 1B]

The circuit configuration of a tracker circuit 1B according to Modification 1 will be described with reference to Figs. 2 and 9. Fig. 9 is a partial circuit diagram of the tracker circuit 1B according to Modification 1.

Fig. 9 illustrates an exemplary circuit configuration. The tracker circuit 1B and a filter circuit 40B may be implemented by using any one of a wide variety of circuit implementations and circuit technologies. Therefore, the description of the filter circuit 40B provided below is not to be construed restrictively.

As illustrated in Figs. 2 and 9, the tracker circuit 1B includes the pre-regulator circuit 10, the switched-capacitor circuit 20, the output switching circuit 30, the filter circuit 40B, the DC power supply 50, the digital control circuit 60, the external connection terminals 141 and 142, and switches S55 to S5A.

The filter circuit 40B is an example of a first filter circuit, and is a pulse shaping network. The filter circuit 40B is configured to be connectable in shunt with the voltage supply paths P41 and P42. The filter circuit 40B is capable of attenuating noise components of signals (a plurality of discrete voltages) transmitted through the voltage supply paths P41 and P42. Specifically, the filter circuit 40B is connected in shunt with the voltage supply path P41 via the switch S55 or S56. That is, the filter circuit 40B is connected between the voltage supply path P41 and ground via the switch S55 or S56. Further, the filter circuit 40B is connected in shunt with the voltage supply path P42 via the switch S58 or S59. That is, the filter circuit 40B is connected between the voltage supply path P42 and ground via the switch S58 or S59.

As illustrated in Fig. 9, the filter circuit 40B includes the inductor L51, an inductor L52, and the capacitor C51 that are connected in series.

The inductor L51 is an example of a first inductor. The inductor L51 is connected between the switches S55 and S58, and between the inductor L52 and the capacitor C51. Specifically, one end of the inductor L51 is connected to the capacitor C51, and the other end of the inductor L51 is connected to the switches S55 and S58 and the inductor L52.

The inductor L52 is an example of a second inductor. The inductor L52 is connected between the switch S56 and the inductor L51, and between the switch S59 and the inductor L51. Specifically, one end of the inductor L52 is connected to the switches S56 and S59, and the other end of the inductor L52 is connected to the inductor L51.

The capacitor C51 is an example of a first capacitor. The capacitor C51 is connected between the inductor L51 and ground. Specifically, one end of the capacitor C51 is connected to the inductor L51, and the other end of the capacitor C51 is connected to ground.

The switches S55 and S56 are an example of a first switch and an example of a second switch, respectively. The switches S55 and S56 are connected in parallel between the voltage supply path P41 and the filter circuit 40B. Specifically, one terminal of the switch S55 is connected to the switch S57 and the external connection terminal 141, and the other terminal of the switch S55 is connected to the inductor L51. One terminal of the switch S56 is connected to the switch S57 and the external connection terminal 141, and the other terminal of the switch S56 is connected to the inductor L52.

The switch S57 is an example of a third switch. The switch S57 is connected in series with the voltage supply path P41. Specifically, one terminal of the switch S57 is connected to the output switching circuit 30, and the other terminal of the switch S57 is connected to the external connection terminal 141. The switch S57 need not necessarily be included in the tracker circuit 1B.

The switches S58 and S59 are an example of a fourth switch and an example of a fifth switch, respectively. The switches S58 and S59 are connected in parallel between the voltage supply path P42 and the filter circuit 40B. Specifically, one terminal of the switch S58 is connected to the switch S5A and the external connection terminal 142, and the other terminal of the switch S58 is connected to the inductor L51. One terminal of the switch S59 is connected to the switch S5A and the external connection terminal 142, and the other terminal of the switch S59 is connected to the inductor L52.

The switch S5A is an example of a sixth switch. The switch S5A is connected in series with the voltage supply path P42. Specifically, one terminal of the switch S5A is connected to the output switching circuit 30, and the other terminal of the switch S5A is connected to the external connection terminal 142. The switch S5A need not necessarily be included in the tracker circuit 1B.

The switches S55 to S5A connected as described above are switched between ON and OFF based on the control signal S4. Specifically, ON/OFF of the switches S55 to S5A is controlled as described below.

(1) In a case where the radio frequency signal RF_{A} is to be amplified by the power amplifier 2A and the radio frequency signals RF_{B} and RF_{C} are not to be amplified by the power amplifier 2B, when the radio frequency signal RF_{A} has a channel band width greater than or equal to a first threshold band width, the switch S57 is closed, and the switches S55, S56, and S58 to S5A are opened. The inductors L51 and L52, and the capacitor C51 are thus disconnected from the voltage supply path P41. At this time, the discrete voltages V_{T1} are supplied to the power amplifier 2A via the external connection terminal 141, but the filter circuit 40B does not function as a band-reject filter with respect to the voltage supply path P41.
(2) In a case where the radio frequency signal RF_{A} is to be amplified by the power amplifier 2A and the radio frequency signals RF_{B} and RF_{C} are not to be amplified by the power amplifier 2B, when the radio frequency signal RF_{A} has a channel band width greater than or equal to a second threshold band width and less than the first threshold band width, the switches S55 and S57 are closed, and the switches S56 and S58 to S5A are opened. The inductor L51 and the capacitor C51 are thus connected in shunt with the voltage supply path P41. At this time, the discrete voltages V_{T1} are supplied to the power amplifier 2A via the external connection terminal 141, and the filter circuit 40B functions as a first band-reject filter with respect to the voltage supply path P41, which is a band-reject filter with a first stopband that depends on the first threshold band width. For example, in a case where the first threshold band width is 75 MHz, the first stopband is a stopband including a frequency (75 MHz) that is equal to the value of the first threshold band width (75 MHz) multiplied by a predetermined coefficient (1.5).
(3) In a case where the radio frequency signal RF_{A} is to be amplified by the power amplifier 2A and the radio frequency signals RF_{B} and RF_{C} are not to be amplified by the power amplifier 2B, when the radio frequency signal RF_{A} has a channel band width less than the second threshold band width, the switches S56 and S57 are closed, and the switches S55 and S58 to S5A are opened. The inductors L51 and L52 and the capacitor C51 are thus connected in shunt with the voltage supply path P41. At this time, the discrete voltages V_{T1} are supplied to the power amplifier 2A via the external connection terminal 141, and the filter circuit 40B functions as a second band-reject filter with respect to the voltage supply path P41, which is a band-reject filter with a second stopband that depends on the second threshold band width. For example, in a case where the second threshold band width is 20 MHz, the second stopband is a stopband including a frequency (30 MHz) that is equal to the value of the second threshold band width (20 MHz) multiplied by a predetermined coefficient (1.5).
(4) In a case where the radio frequency signal RF_{B} or RF_{C} is to be amplified by the power amplifier 2B and the radio frequency signal RF_{A} is not to be amplified by the power amplifier 2A, when the radio frequency signal RF_{B} or RF_{C} has a channel band width greater than or equal to the first threshold band width, the switch S5A is closed, and the switches S55 to S59 are opened. The inductors L51 and L52, and the capacitor C51 are thus disconnected from the voltage supply path P42. At this time, the discrete voltages V_{T2} are supplied to the power amplifier 2B via the external connection terminal 142, but the filter circuit 40B does not function as a band-reject filter with respect to the voltage supply path P42.
(5) In a case where the radio frequency signal RF_{B} or RF_{C} is to be amplified by the power amplifier 2B and the radio frequency signal RF_{A} is not to be amplified by the power amplifier 2A, when the radio frequency signal RF_{B} or RF_{C} has a channel band width greater than or equal to the second threshold band width and less than the first threshold band width, the switches S58 and S5A are closed, and the switches S55 to S57 and S59 are opened. The inductor L51 and the capacitor C51 are thus connected in shunt with the voltage supply path P42. At this time, the discrete voltages V_{T2} are supplied to the power amplifier 2B via the external connection terminal 142, and the filter circuit 40B functions as a first band-reject filter with a first stopband with respect to the voltage supply path P42.
(6) In a case where the radio frequency signal RF_{B} or RF_{C} is to be amplified by the power amplifier 2B and the radio frequency signal RF_{A} is not to be amplified by the power amplifier 2A, when the radio frequency signal RF_{B} or RF_{C} has a channel band width less than the second threshold band width, the switches S59 and S5A are closed, and the switches S55 to S58 are opened. The inductors L51 and L52 and the capacitor C51 are thus connected in shunt with the voltage supply path P42. At this time, the discrete voltages V_{T2} are supplied to the power amplifier 2B via the external connection terminal 142, and the filter circuit 40B functions as a second band-reject filter with a second stopband with respect to the voltage supply path P42.

The first threshold band width and the second threshold band width to be used in the above-mentioned control of the switches S55 to S5A may be experimentally and/or empirically determined in advance. The first threshold band width to be used may be a frequency band width (e.g., 100 MHz) greater than the second threshold band width, and the second threshold band width to be used may be a frequency band width (e.g., 50 MHz) less than the first threshold band width.

With the above-described switch control, the filter circuit 40B functions as a variable band-reject filter with a stopband that varies with the channel band width.

The respective values of first threshold band width, the second threshold band width, and the predetermined coefficient are illustrative and not intended to be limiting.

### [2.2 Advantageous Effects, etc.]

As described above, the tracker circuit 1B according to Modification 1 may further include: the switches S55 and S56 connected in parallel between the voltage supply path P41 and the filter circuit 40B; the switch S57 connected between the output switching circuit 30 and the power amplifier 2A (external connection terminal 141); the switches S58 and S59 connected in parallel between the voltage supply path P42 and the filter circuit 40B; and the switch S5A connected between the output switching circuit 30 and the power amplifier 2B (external connection terminal 142). The filter circuit 40B may include the inductors L51 and L52 and the capacitor C51 that are connected in series. One terminal of the switch S55 and one terminal of the switch S56 may be connected to the voltage supply path P41. One terminal of the switch S58 and one terminal of the switch S59 may be connected to the voltage supply path P42. The other terminal of the switch S55 and the other terminal of the switch S58 may be connected to one end of the inductor L51 and one end of the inductor L52. The other terminal of the switch S56 and the other terminal of the switch S59 may be connected to the other end of the inductor L52. The capacitor C51 may be connected between the other end of the inductor L51 and ground.

According to the configuration mentioned above, the switches S55 to S5A enable switching between connection and disconnection of the filter circuit 40B to and from the voltage supply paths P41 and P42. Further, in connecting the filter circuit 40B to the voltage supply paths P41 and P42, switching can be made between the shunt connection of the inductors L51 and L52 and the capacitor C51, and the shunt connection of the inductor L51 and the capacitor C51. This allows the stopband of the filter circuit 40B to be varied to enable selection of a stopband suitable for reducing IMD in the power amplifiers 2A and 2B. This may result in effective reduction of spurious emissions in the power amplifiers 2A and 2B.

For example, in the tracker circuit 1B according to Modification 1, in a case where the radio frequency signal RF_{A} is to be amplified by the power amplifier 2A, (i) when the radio frequency signal RF_{A} has a channel band width greater than or equal to a first threshold band width, the switch S57 may be closed, and the switches S55, S56, and S58 to S5A may be opened, (ii) when the radio frequency signal RF_{A} has a channel band width greater than or equal to a second threshold band width and less than the first threshold band width, the switches S55 and S57 may be closed, and the switches S56 and S58 to S5A may be opened, and (iii) when the radio frequency signal RF_{A} has a channel band width less than the second threshold band width, the switches S56 and S57 may be closed, and the switches S55 and S58 to S5A may be opened. In a case where the radio frequency signal RF_{B} or RF_{C} is to be amplified by the power amplifier 2B, (i) when the radio frequency signal RF_{B} or RF_{C} has a channel band width greater than or equal to the first threshold band width, the switch S5A may be closed, and the switches S55 to S59 may be opened, (ii) when the radio frequency signal RF_{B} or RF_{C} has a channel band width greater than or equal to the second threshold band width and less than the first threshold band width, the switches S58 and S5A may be closed, and the switches S55 to S57 and S59 may be opened, and (iii) when the radio frequency signal RF_{B} or RF_{C} has a channel band width less than the second threshold band width, the switches S59 and S5A may be closed, and the switches S55 to S58 may be opened.

According to the configuration mentioned above, when the radio frequency signal RF_{A} has a narrow channel band width, the filter circuit 40B can be connected in shunt with the voltage supply path P41, and when the radio frequency signal RF_{B} or RF_{C} has a narrow channel band width, the filter circuit 40B can be connected to the voltage supply path P42. This makes it possible to reduce noise at the frequencies that cause IMD affecting ACP, and thus effectively reduce spurious emissions (i.e., ACP) in the power amplifiers 2A and 2B. Further, switching between connection and disconnection of the inductor L52 can be made in accordance with the channel band widths of the radio frequency signals RF_{A} to RF_{C}. This makes it possible to achieve a stopband adapted to the channel band width, which in turn allows for more effective reduction of spurious emissions in the power amplifiers 2A and 2B. When the radio frequency signals RF_{A} and RF_{B} have a wide channel band width, the filter circuit 40B can be disconnected from the voltage supply paths P41 and P42. This makes it possible to reduce degradation of the responsiveness of the voltage supply paths P41 and P42, and thus effectively reduce degradation of the discrete voltages in the voltage supply paths P41 and P42.

### (Modification 2 of Embodiment 1)

Modification 2 of Embodiment 1 will now be described. Modification 2 differs from Modification 1 of Embodiment 1 mainly in the connection between the filter circuit and the voltage supply paths, and the number of switches used for the connection. A tracker circuit according to Modification 2 will be described below with reference to the drawings, with focus on differences from Modification 1.

### [3.1 Circuit Configuration of Tracker Circuit 1C]

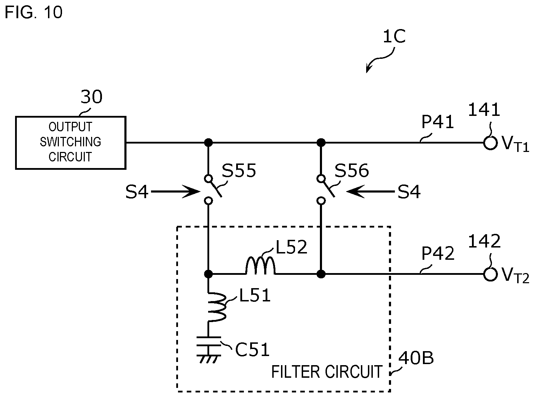

The circuit configuration of a tracker circuit 1C according to Modification 2 will be described with reference to Figs. 2 and 10. Fig. 10 is a partial circuit diagram of the tracker circuit 1C according to Modification 2.

Figs. 2 and 10 each illustrate an exemplary circuit configuration. The tracker circuit 1C and the filter circuit 40B may be implemented by using any one of a wide variety of circuit implementations and circuit technologies. Therefore, the description of the tracker circuit 1C and the filter circuit 40B provided below is not to be construed restrictively.

As illustrated in Figs. 2 and 10, the tracker circuit 1C includes the pre-regulator circuit 10, the switched-capacitor circuit 20, the output switching circuit 30, the filter circuit 40B, the DC power supply 50, the digital control circuit 60, the external connection terminals 141 and 142, and the switches S55 and S56.

The filter circuit 40B is an example of a first filter circuit. The filter circuit 40B is configured to be connectable in shunt with the voltage supply paths P41 and P42. The filter circuit 40B is capable of attenuating noise components of signals (a plurality of discrete voltages) transmitted through the voltage supply paths P41 and P42. Specifically, the filter circuit 40B is connected in shunt with the voltage supply path P41 via the switch S55 or S56. That is, the filter circuit 40B is connected between the voltage supply path P41 and ground via the switch S55 or S56. Further, the filter circuit 40B is connected in shunt with the voltage supply path P42 via the switch S55 or S56. That is, the filter circuit 40B is connected between the voltage supply path P42 and ground via the switch S55 or S56.

As illustrated in Fig. 10, the filter circuit 40B includes the inductor L51, the inductor L52, and the capacitor C51 that are connected in series.

The inductor L51 is an example of a first inductor. The inductor L51 is connected between the switch S55 and the capacitor C51, and between the inductor L52 and the capacitor C51. Specifically, one end of the inductor L51 is connected to the switch S55 and the inductor L52, and the other end of the inductor L51 is connected to the capacitor C51.

The inductor L52 is an example of a second inductor. The inductor L52 is connected between the switch S55 and the external connection terminal 142, and between the switch S56 and the inductor L51. Specifically, one end of the inductor L52 is connected to the switch S55 and the inductor L51, and the other end of the inductor L52 is connected to the switch S56 and the external connection terminal 142.

According to Modification 2, the inductor L52 may, in some cases, be connected in series with the voltage supply path P42. That is, a larger current flows through the inductor L52 than through the inductor L51. Accordingly, the inductor L52 has a larger rated current than the inductor L51. The inductor L52 thus has a larger size than the inductor L51.

A rated current refers to the value of applied DC current above which quality can no longer be guaranteed. In this case, the rated current of each inductor is a so-called DC superimposed rated current, and can be determined by measuring the value of current at which the inductance value decreases by 30% relative to the initial inductance value with no current superposed.

The capacitor C51 is an example of a first capacitor. The capacitor C51 is connected between the inductor L51 and ground. Specifically, one end of the capacitor C51 is connected to the inductor L51, and the other end of the capacitor C51 is connected to ground.

The switches S55 and S56 are an example of a first switch and an example of a second switch, respectively. The switches S55 and S56 are connected in parallel between the voltage supply path P41 and the filter circuit 40B. Specifically, one terminal of the switch S55 is connected to the voltage supply path P41, and the other terminal of the switch S55 is connected to the inductors L51 and L52. One terminal of the switch S56 is connected to the voltage supply path P41, and the other terminal of the switch S56 is connected to the inductor L52 and the external connection terminal 142.

The switches S55 to S56 connected as described above are switched between ON and OFF based on the control signal S4. Specifically, ON/OFF of the switches S55 to S56 is controlled as described below.

(1) In a case where the radio frequency signal RF_{A} is to be amplified by the power amplifier 2A and the radio frequency signals RF_{B} and RF_{C} are not to be amplified by the power amplifier 2B, when the radio frequency signal RF_{A} has a channel band width greater than or equal to a first threshold band width, the switches S55 and S56 are opened. The inductors L51 and L52, and the capacitor C51 are thus disconnected from the voltage supply path P41. At this time, the discrete voltages V_{T1} are supplied to the power amplifier 2A via the external connection terminal 141, but the filter circuit 40B does not function as a band-reject filter with respect to the voltage supply path P41.
(2) In a case where the radio frequency signal RF_{A} is to be amplified by the power amplifier 2A and the radio frequency signals RF_{B} and RF_{C} are not to be amplified by the power amplifier 2B, when the radio frequency signal RF_{A} has a channel band width greater than or equal to a second threshold band width and less than the first threshold band width, the switch S55 is closed, and the switch S56 is opened. The inductor L51 and the capacitor C51 are thus connected in shunt with the voltage supply path P41. At this time, the discrete voltages V_{T1} are supplied to the power amplifier 2A via the external connection terminal 141, and the filter circuit 40B functions as a first band-reject filter with respect to the voltage supply path P41, which is a band-reject filter with a first stopband that depends on the first threshold band width. For example, when the first threshold band width is 50 MHz, the first stopband is a stopband including a frequency (75 MHz) that is equal to the value of the first threshold band width (50 MHz) multiplied by a predetermined coefficient (1.5).
(3) In a case where the radio frequency signal RF_{A} is to be amplified by the power amplifier 2A and the radio frequency signals RF_{B} and RF_{C} are not to be amplified by the power amplifier 2B, when the radio frequency signal RF_{A} has a channel band width less than the second threshold band width, the switch S55 is opened, and the switch S56 is closed. The inductors L51 and L52 and the capacitor C51 are thus connected in shunt with the voltage supply path P41. At this time, the discrete voltages V_{T1} are supplied to the power amplifier 2A via the external connection terminal 141, and the filter circuit 40B functions as a second band-reject filter with respect to the voltage supply path P41, which is a band-reject filter with a second stopband that depends on the second threshold band width. For example, when the second threshold band width is 20 MHz, the second stopband is a stopband including a frequency (30 MHz) that is equal to the value of the second threshold band width (20 MHz) multiplied by a predetermined coefficient (1.5).
(4) In a case where the radio frequency signal RF_{B} is to be amplified by the power amplifier 2B and the radio frequency signal RF_{A} is not to be amplified by the power amplifier 2A, when the radio frequency signal RF_{B} has a channel band width greater than or equal to the second threshold band width, the switch S55 is closed, and the switch S56 is opened. Thus, the inductor L51 and the capacitor C51 are connected in shunt with the voltage supply path P42, and the inductor L52 is connected in series with the voltage supply path P42. At this time, the discrete voltages V_{T2} are supplied to the power amplifier 2B via the external connection terminal 142, and the filter circuit 40B functions as a third band-reject filter with a third stopband with respect to the voltage supply path P42.
(5) In a case where the radio frequency signal RF_{B} is to be amplified by the power amplifier 2B and the radio frequency signal RF_{A} is not to be amplified by the power amplifier 2A, when the radio frequency signal RF_{B} has a channel band width less than the second threshold band width, the switch S55 is opened, and the switch S56 is closed. The inductors L51 and L52 and the capacitor C51 are thus connected in shunt with the voltage supply path P42. At this time, the discrete voltages V_{T2} are supplied to the power amplifier 2B via the external connection terminal 142, and the filter circuit 40B functions as a second band-reject filter with a second stopband with respect to the voltage supply path P42.
(6) In a case where the radio frequency signal RF_{C} is to be amplified by the power amplifier 2B and the radio frequency signal RF_{A} is not to be amplified by the power amplifier 2A, the switch S55 is closed, and the switch S56 is opened. Thus, the inductor L51 and the capacitor C51 are connected in shunt with the voltage supply path P42, and the inductor L52 is connected in series with the voltage supply path P42. At this time, the discrete voltages V_{T2} are supplied to the power amplifier 2B via the external connection terminal 142, and the filter circuit 40B functions as a third band-reject filter with a third stopband with respect to the voltage supply path P42.

The first threshold band width and the second threshold band width to be used in the above-mentioned control of the switches S55 to S56 may be threshold band widths similar to those according to Modification 1 of Embodiment 1.

With the above-described switch control, the filter circuit 40B functions as a variable band-reject filter with a stopband that varies with the channel band width.

### [3.2 Advantageous effects, etc.]

As described above, the tracker circuit 1C according to Modification 2 may further include the switches S55 and S56 connected in parallel between the voltage supply path P41 and the filter circuit 40B. The filter circuit 40B may include the inductors L51 and L52 and the capacitor C51 that are connected in series. One terminal of the switch S55 and one terminal of the switch S56 may be connected to the first voltage supply path. The other terminal of the switch S55 may be connected to one end of the inductor L51 and one end of the inductor L52. The other terminal of the switch S56 may be connected to the other end of the inductor L52 and the second power amplifier (external connection terminal 142). The capacitor C51 may be connected between the other end of the inductor L51 and ground.

According to the configuration mentioned above, the switches S55 and S56 enable switching of connections between the inductor L52 and the voltage supply paths P41 and P42. This allows the stopband of the filter circuit 40B to be varied. In particular, as for the voltage supply path P41, the two switches S55 and S56 enable switching between the following states: disconnecting the inductors L51 and L52 and the capacitor C51 from the voltage supply path P41; connecting, in shunt with the voltage supply path P41, the inductor L51 and the capacitor C51; and connecting, in shunt with the voltage supply path P41, the inductors L51 and L52 and the capacitor C51. As for the voltage supply path P42, the two switches S55 and S56 enable switching between the following states: connecting, in shunt with the voltage supply path P42, the inductor L51 and the capacitor C51, and connecting the inductor L52 in series with the voltage supply path P42; and connecting, in shunt with the voltage supply path P42, the inductors L51 and L52 and the capacitor C51. In this way, for the filter circuit 40B, the two switches S55 and S56 make it possible to achieve switching between a plurality of stopbands with respect to the two voltage supply paths P41 and P42.

For example, in the tracker circuit 1C according to Modification 2, in a case where the radio frequency signal RF_{A} is to be amplified by the power amplifier 2A, (i) when the radio frequency signal RF_{A} has a channel band width greater than or equal to a first threshold band width, the switches S55 and S56 may be opened, (ii) when the radio frequency signal RF_{A} has a channel band width greater than or equal to a second threshold band width and less than the first threshold band width, the switch S55 may be closed, and the switch S56 may be opened, and (iii) when the radio frequency signal RF_{A} has a channel band width less than the second threshold band width, the switch S55 may be opened, and the switch S56 may be closed. In a case where the radio frequency signal RF_{B} is to be amplified by the power amplifier 2B, (i) when the radio frequency signal RF_{B} has a channel band width greater than or equal to the second threshold band width, the switch S55 may be closed, and the switch S56 may be opened, and (ii) when the radio frequency signal RF_{B} has a channel band width less than the second threshold band width, the switch S55 may be opened, and the switch S56 may be closed.

The configuration mentioned above makes it possible to switch between ON and OFF of the switches S55 and S56 in accordance with the band and channel band width of a radio frequency signal, and consequently achieve the balance between reduction of noise and reduction of degradation of the discrete voltages in the voltage supply paths P41 and P42.

For example, in the tracker circuit 1C according to Modification 2, Band A may be included in the range of 3300 to 5000 MHz, and Bands B and C may each be included in the range of 1427 to 2690 MHz.

The configuration mentioned above allows the tracker circuit 1C to achieve, for a band that has a greater available channel band width and is higher in frequency, a greater number of types of stopbands in accordance with the channel band width. This makes it possible to more finely control the stopband in accordance with the channel band width, and thus effectively reduce spurious emissions in the power amplifiers 2A and 2B.

For example, in the tracker circuit 1C according to Modification 2, the inductor L52 may have a larger rated current than the inductor L51.

According to the configuration mentioned above, the inductor L52, which may be connected in series with the voltage supply path P42, can be made to have a higher rated current than the inductor L51, which is not connected in series with the voltage supply paths P41 and P42. This contributes to stable operation of the tracker circuit 1C.

### (Embodiment 2)

Embodiment 2 will now be described. A tracker circuit according to Embodiment 2 differs from the tracker circuits according to Embodiment 1 and the modifications thereof mainly in that the tracker circuit is capable of supplying a plurality of discrete voltages to three different power amplifiers. The tracker circuit according to Embodiment 2 will be described below with reference to the drawings, with particular focus on differences from Modification 2 of Embodiment 1.

### [4.1 Circuit Configuration of Communication Device 7D]

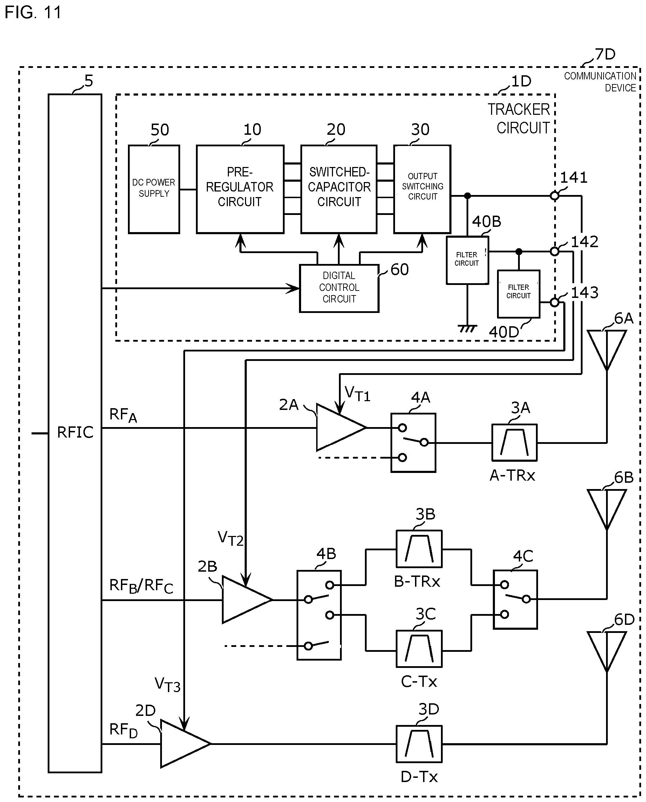

A communication device 7D according to Embodiment 2 will now be described with reference to Fig. 11. Fig. 11 is a circuit diagram of the communication device 7D according to Embodiment 2.

Fig. 11 illustrates an exemplary circuit configuration. The communication device 7D may be implemented by using any one of a wide variety of circuit implementations and circuit technologies. Therefore, the description of the communication device 7D provided below is not to be construed restrictively.

As illustrated in Fig. 11, the communication device 7D includes a tracker circuit 1D, power amplifiers 2A, 2B, and 2D, filters 3A to 3D, switches 4A to 4C, an RFIC 5, and antennas 6A, 6B, and 6D.

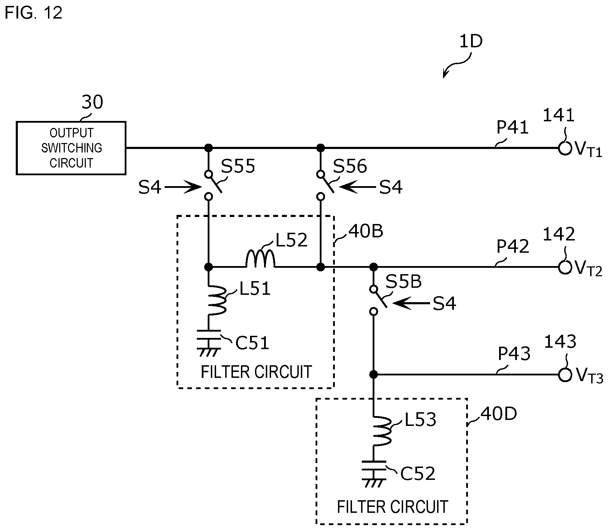

The tracker circuit 1D is capable of supplying the power amplifiers 2A and 2B with a plurality of discrete voltages V_{T1} and a plurality of discrete voltages V_{T2}, respectively, based on a tracking mode. The tracker circuit 1D is further capable of supplying the power amplifier 2D with a plurality of discrete voltages V_{T3} based on a tracking mode. As illustrated in Fig. 11, the tracker circuit 1D includes a pre-regulator circuit 10, a switched-capacitor circuit 20, an output switching circuit 30, filter circuits 40B and 40D, a DC power supply 50, a digital control circuit 60, external connection terminals 141 to 143, and switches S55, S56, and S5B (see Fig. 12).

The external connection terminal 143 is an example of a third external connection terminal. The external connection terminal 143 is connected at a location outside the tracker circuit 1D to the power amplifier 2D, and connected at a location inside the tracker circuit 1D to the output switching circuit 30 via a voltage supply path P43.

The voltage supply path P43 is an example of a third voltage supply path. The voltage supply path P43 is part of a path connecting the output switching circuit 30 and the power amplifier 2D. In this case, the voltage supply path P43 serves to connect the output switching circuit 30 and the external connection terminal 143, and partially overlaps the voltage supply paths P41 and P42. Alternatively, the voltage supply path P43 may be entirely non-overlapping with the voltage supply paths P41 and P42.

The power amplifier 2D is an example of a third power amplifier. The power amplifier 2D is connected between the RFIC 5 and the filter 3D. Further, the power amplifier 2D is connected to the tracker circuit 1D. The power amplifier 2D is capable of amplifying, by using the discrete voltages V_{T3} received from the tracker circuit 1D, a radio frequency signal RF_{D} (an example of a third radio frequency signal) of Band D received from the RFIC 5.

The filter 3D is connected between the power amplifier 2D and the antenna 6D. The filter 3D is a band pass filter with a passband that includes the transmission band of Band D.

Band D is a frequency band for communication systems built by using RAT. Band D is predefined by a standardizing body or other entities. Band D is an example of a third band, and is an FDD band according to Embodiment 2. According to Embodiment 2, Band D is included in the low band group (698 to 960 MHz). Band D is limited neither to an FDD band nor to a frequency band included in the low band group.

The antenna 6D outputs a transmission signal of Band D received from the power amplifier 2D via the filter 3D. The antenna 6D need not necessarily be included in the communication device 7D.

### [4.2 Circuit Configuration of Tracker Circuit 1D]

The circuit configuration of the tracker circuit 1D will now be described with reference to Figs. 11 and 12. Fig. 12 is a partial circuit diagram of the tracker circuit 1D according to Embodiment 2.

Fig. 12 illustrates an exemplary circuit configuration. The tracker circuit 1D and the filter circuit 40D may be implemented by using any one of a wide variety of circuit implementations and circuit technologies. Therefore, the description of the tracker circuit 1D and the filter circuit 40D provided below is not to be construed restrictively.

The filter circuit 40D is an example of a second filter circuit. The filter circuit 40D is configured to be connectable in shunt with the voltage supply paths P41 to P43. The filter circuit 40D is capable of attenuating noise components of signals (a plurality of discrete voltages) transmitted through the voltage supply paths P41 to P43. Specifically, as illustrated in Fig. 12, the filter circuit 40D includes an inductor L53 and a capacitor C52 that are connected in series.

The inductor L53 is an example of a third inductor. The inductor L53 is connected between the voltage supply path P43 and the capacitor C52. Specifically, one end of the inductor L53 is connected to the switch S5B and the external connection terminal 143, and the other end of the inductor L53 is connected to the capacitor C52.

The capacitor C52 is an example of a second capacitor. The capacitor C52 is connected between the inductor L53 and ground. Specifically, one end of the capacitor C52 is connected to the inductor L53, and the other end of the capacitor C52 is connected to ground.

The switch S5B is an example of a third switch. The switch S5B is connected between the output switching circuit 30 and the external connection terminal 143, and between the voltage supply path P42 and the inductor L53. Specifically, one terminal of the switch S5B is connected to the inductor L52 and the external connection terminal 142, and the other terminal of the switch S5B is connected to the inductor L53 and the external connection terminal 143.

The switch S5B connected as described above is switched between ON and OFF based on a control signal S4. Specifically, ON/OFF of the switches S55, S56, and S5B is controlled as described below.

(1) In a case where the radio frequency signal RF_{A} is to be amplified by the power amplifier 2A and a radio frequency signal is to be amplified by neither of the power amplifiers 2B and 2D, when the radio frequency signal RF_{A} has a channel band width greater than or equal to a first threshold band width, the switches S55, S56, and S5B are opened. The inductors L51 to L53 and the capacitors C51 and C52 are thus disconnected from the voltage supply path P41. At this time, the discrete voltages V_{T1} are supplied to the power amplifier 2A via the external connection terminal 141, but the filter circuits 40B and 40D do not function as a band-reject filter with respect to the voltage supply path P41.
(2) In a case where the radio frequency signal RF_{A} is to be amplified by the power amplifier 2A and a radio frequency signal is to be amplified by neither of the power amplifiers 2B and 2D, when the radio frequency signal RF_{A} has a channel band width greater than or equal to a second threshold band width and less than the first threshold band width, the switch S55 is closed, and the switches S56 and S5B are opened. The inductor L51 and the capacitor C51 are thus connected in shunt with the voltage supply path P41. At this time, the discrete voltages V_{T1} are supplied to the power amplifier 2A via the external connection terminal 141, and the filter circuit 40B functions as a first band-reject filter with respect to the voltage supply path P41, which is a band-reject filter with a first stopband that depends on the first threshold band width.
(3) In a case where the radio frequency signal RF_{A} is to be amplified by the power amplifier 2A and a radio frequency signal is to be amplified by neither of the power amplifiers 2B and 2D, when the radio frequency signal RF_{A} has a channel band width less than the second threshold band width, the switch S55 is opened, and the switches S56 and S5B are closed. Thus, the inductors L51 and L52 and the capacitor C51 are connected in shunt with the voltage supply path P41 and, further, the inductor L53 and the capacitor C52 are also connected in shunt with the voltage supply path P41. At this time, the discrete voltages V_{T1} are supplied to the power amplifier 2A via the external connection terminal 141, and the filter circuits 40B and 40D function as a second band-reject filter with respect to the voltage supply path P41, which is a band-reject filter with a second stopband that depends on the second threshold band width.
(4) In a case where the radio frequency signal RF_{B} is to be amplified by the power amplifier 2B and a radio frequency signal is to be amplified by neither of the power amplifiers 2A and 2D, when the radio frequency signal RF_{B} has a channel band width greater than or equal to the second threshold band width, the switch S55 is closed, and the switches S56 and S5B are opened. Thus, the inductor L51 and the capacitor C51 are connected in shunt with the voltage supply path P42, and the inductor L52 is connected in series with the voltage supply path P42. At this time, the discrete voltages V_{T2} are supplied to the power amplifier 2B via the external connection terminal 142, and the filter circuit 40B functions as a third band-reject filter with a third stopband with respect to the voltage supply path P42.
(5) In a case where the radio frequency signal RF_{B} is to be amplified by the power amplifier 2B and a radio frequency signal is to be amplified by neither of the power amplifiers 2A and 2D, when the radio frequency signal RF_{B} has a channel band width less than the second threshold band width, the switch S55 is opened, and the switches S56 and S5B are closed. Thus, the inductors L51 and L52 and the capacitor C51 are connected in shunt with the voltage supply path P42 and, further, the inductor L53 and the capacitor C52 are also connected in shunt with the voltage supply path P42. At this time, the discrete voltages V_{T2} are supplied to the power amplifier 2B via the external connection terminal 142, and the filter circuits 40B and 40D function as a second band-reject filter with a second stopband with respect to the voltage supply path P42.
(6) In a case where the radio frequency signal RF_{C} is to be amplified by the power amplifier 2B and a radio frequency signal is to be amplified by neither of the power amplifiers 2A and 2D, the switch S55 is closed, and the switches S56 and S5B are opened. Thus, the inductor L51 and the capacitor C51 are connected in shunt with the voltage supply path P42, and the inductor L52 is connected in series with the voltage supply path P42. At this time, the discrete voltages V_{T2} are supplied to the power amplifier 2B via the external connection terminal 142, and the filter circuit 40B functions as a third band-reject filter with a third stopband with respect to the voltage supply path P42.
(7) In a case where the radio frequency signal RF_{D} is to be amplified by the power amplifier 2D and a radio frequency signal is to be amplified by neither of the power amplifiers 2A and 2B, the switch S55 is opened, and the switches S56 and S5B are closed. Thus, the inductors L51 and L52 and the capacitor C51 are connected in shunt with the voltage supply path P43 and, further, the inductor L53 and the capacitor C52 are also connected in shunt with the voltage supply path P43. At this time, the discrete voltages V_{T3} are supplied to the power amplifier 2D via the external connection terminal 143, and the filter circuits 40B and 40D function as a second band-reject filter with a second stopband with respect to the voltage supply path P43.

The first threshold band width and the second threshold band width to be used in the above-mentioned control of the switches S55, S56, and S5B may be threshold band widths similar to those according to Modification 1 of Embodiment 1.

With the above-described switch control, the filter circuits 40B and 40D function as a variable band-reject filter with a stopband that varies with the channel band width.

### [4.3 Advantageous Effects, etc.]

As described above, in the tracker circuit 1D according to Embodiment 2, the output switching circuit 30 may further be configured to selectively output at least one of a plurality of discrete voltages to the power amplifier 2D. The power amplifier 2D may be configured to amplify the radio frequency signal RF_{D} of Band D. The tracker circuit 1D may further include: the voltage supply path P43 that connects the output switching circuit 30 and the power amplifier 2D; the filter circuit 40D connectable in shunt with the voltage supply paths P41, P42, and P43; the switches S55 and S56 connected in parallel between the voltage supply path P41 and the filter circuit 40B; and the switch S5B connected between the voltage supply path P42 and the filter circuit 40D. The filter circuit 40B may include the inductors L51 and L52 and the capacitor C51 that are connected in series. The filter circuit 40D may include the inductor L53 and the capacitor C52 that are connected in series. One terminal of the switch S55 and one terminal of the switch S56 may be connected to the voltage supply path P41. The other terminal of the switch S55 may be connected to one end of the inductor L51 and one end of the inductor L52. The other terminal of the switch S56 may be connected to the other end of the inductor L52 and the power amplifier 2B. The capacitor C51 may be connected between the other end of the inductor L51 and ground. One terminal of the switch S5B may be connected to the other end of the inductor L52 and the power amplifier 2B in the voltage supply path P42. The other terminal of the switch S5B may be connected to one end of the inductor L53 and the power amplifier 2D. The capacitor C52 may be connected between the other end of the inductor L53 and ground.

The tracker circuit 1D according to Embodiment 2 may further include: the external connection terminal 143 connected to the power amplifier 2D; the voltage supply path P43 connecting the output switching circuit 30 and the external connection terminal 143; the filter circuit 40D that is connected between the voltage supply path P41 and ground, that is connected between the voltage supply path P42 and ground, and that is connected between the voltage supply path P43 and ground; the switches S55 and S56 that are connected in parallel between the voltage supply path P41 and the filter circuit 40B; and the switch S5B connected between the voltage supply path P42 and the filter circuit 40D. The filter circuit 40B may include the inductors L51 and L52 and the capacitor C51 that are connected in series. The filter circuit 40D may include the inductor L53 and the capacitor C52 that are connected in series. One terminal of the switch S55 and one terminal of the switch S56 may be connected to the voltage supply path P41. The other terminal of the switch S55 may be connected to one end of the inductor L51 and one end of the inductor L52. The other terminal of the switch S56 may be connected to the other end of the inductor L52 and the external connection terminal 142. The capacitor C51 may be connected between the other end of the inductor L51 and ground. One terminal of the switch S5B may be connected to the other end of the inductor L52 and the external connection terminal 142 in the voltage supply path P42. The other terminal of the switch S5B may be connected to one end of the inductor L53 and the external connection terminal 143. The capacitor C52 may be connected between the other end of the inductor L53 and ground.

According to the configuration mentioned above, the switches S55 to S5B enable switching of connections of a subset or all of the inductors L51 to L53 and the capacitors C51 and C52 to the voltage supply paths P41 to P43. This allows the stopband of the filter circuit 40D to be varied. In particular, as for the voltage supply path P41, the three switches S55 to S5B enable switching between the following states: disconnecting the inductors L51 to L53 and the capacitors C51 and C52 from the voltage supply path P41; connecting, in shunt with the voltage supply path P41, the inductor L51 and the capacitor C51; and connecting, in shunt with the voltage supply path P41, the inductors L51 to L53 and the capacitors C51 and C52. As for the voltage supply path P42, the three switches S55 to S5B enable switching between the following states: connecting, in shunt with the voltage supply path P42, the inductor L51 and the capacitor C51, and connecting the inductor L52 in series with the voltage supply path P42; and connecting, in shunt with the voltage supply path P42, the inductors L51 to L53 and the capacitors C51 and C52. In this way, for the filter circuit 40D, the three switches S55 to S5B make it possible to achieve switching between a plurality of stopbands with respect to the three voltage supply paths P41 to P43.

For example, in the tracker circuit 1D according to Embodiment 2, in a case where the radio frequency signal RF_{A} is to be amplified by the power amplifier 2A, (i) when the radio frequency signal RF_{A} has a channel band width greater than or equal to a first threshold band width, the switches S55, S56, and S5B may be opened, (ii) when the radio frequency signal RF_{A} has a channel band width greater than or equal to a second threshold band width and less than the first threshold band width, the switch S55 may be closed, and the switches S56 and S5B may be opened, and (iii) when the radio frequency signal RF_{A} has a channel band width less than the second threshold band width, the switch S55 may be opened, and the switches S56 and S5B may be closed. In a case where the radio frequency signal RF_{B} is to be amplified by the power amplifier 2B, (i) when the radio frequency signal RF_{B} has a channel band width greater than or equal to the second threshold band width, the switch S55 may be closed, and the switches S56 and S5B may be opened, and (ii) when the radio frequency signal RF_{B} has a channel band width less than the second threshold band width, the switch S55 may be opened, and the switches S56 and S5B may be closed. In a case where the radio frequency signal RF_{D} is to be amplified by the power amplifier 2D, the switch S55 may be opened, and the switches S56 and S5B may be closed.

The configuration mentioned above makes it possible to switch between ON and OFF of the switches S55, S56, and S5B in accordance with the band and channel band width of a radio frequency signal, and consequently achieve the balance between reduction of noise and reduction of degradation of the discrete voltages in the voltage supply paths P41 to P43.

For example, in the tracker circuit 1D according to Embodiment 2, Band A may be included in the range of 3300 to 5000 MHz, Bands B and C may each be included in the range of 1427 to 2690 MHz, and Band D may be included in the range of 698 to 960 MHz.

The configuration mentioned above allows the filter circuit 40D to achieve, for a band that has a greater available channel band width and is higher in frequency, a greater number of types of stopbands in accordance with the channel band width. This makes it possible to more finely control the stopband in accordance with the channel band width, and thus effectively reduce spurious emissions in the power amplifiers 2A, 2B, and 2D.

### (Other Embodiments)

Although the tracker circuit and the tracking method according to the present invention have been described above based on embodiments thereof, the tracker circuit and the tracking method according to the present invention are not limited to the embodiments mentioned above. The present invention is intended to also encompass: other embodiments implemented by combining any constituent elements in the above embodiments; modifications obtained by modifying the above embodiments in various ways as may become apparent to those skilled in the art without departing from the scope of the present invention; and various devices incorporating the tracker circuit mentioned above.

For example, in the circuit configurations of the various circuits according to the above embodiments, another circuit element, wiring line, and other features may be inserted between individual circuit elements and paths connecting signal paths disclosed in the drawings. For example, an impedance matching circuit may be inserted between the power amplifier 2A and the filter 3A.

According to the above embodiments, a plurality of discrete voltages are supplied from the switched-capacitor circuit to the output switching circuit. This configuration, however, is not intended to be limiting. For example, a plurality of voltages may each be supplied from a corresponding one of a plurality of DC-DC converters. If the levels of the discrete voltages are at equal intervals, use of a switched-capacitor circuit is preferred, and effective in reducing the size of the tracker module.

According to the above embodiments, four discrete voltages are supplied to a power amplifier. The number of discrete voltages, however, is not limited to four. For example, improved PAE can be achieved as long as a plurality of discrete voltages include at least the following voltages: a voltage corresponding to the maximum output power; and a voltage corresponding to the output power with the highest frequency of occurrence.

According to Embodiment 1 described above, the circuit components of the tracker circuit 1A are disposed on the major face 90a of the module laminate 90. Alternatively, the circuit components may be disposed on both the major faces 90a and 90b. In this case, for example, the integrated circuit 80 may be disposed on the major face 90b.

According to the above embodiments, ON/OFF of a switch that connects a filter circuit to a voltage supply path is controlled based on the channel band width of a radio frequency signal. This configuration, however, is not intended to be limiting. For example, if one power amplifier is capable of amplifying radio frequency signals of a plurality of bands, ON/OFF of the switch may be controlled based on the band of the radio frequency signal to be amplified by the power amplifier.

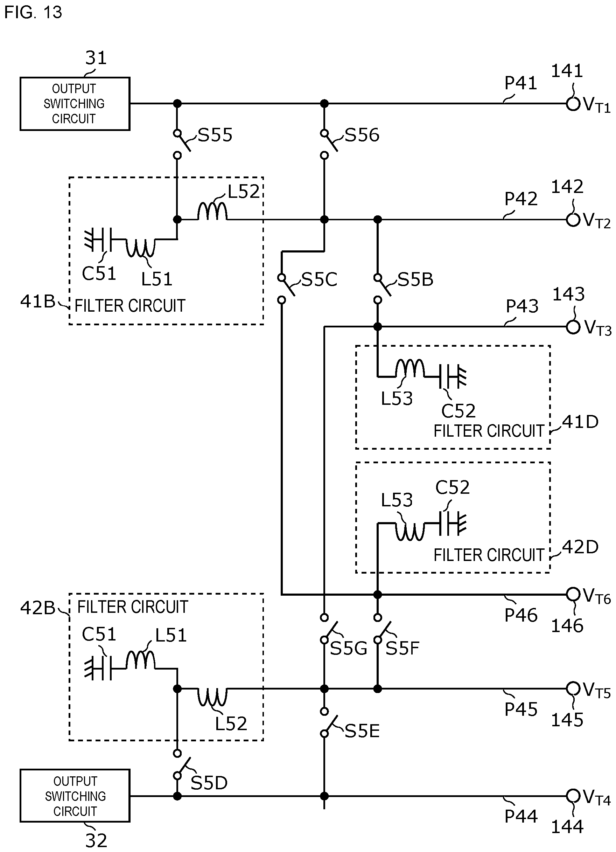

According to the above embodiments, the tracker circuit includes a single output switching circuit 30. Alternatively, the tracker circuit may include a plurality of output switching circuits. For example, as illustrated in Fig. 13, the tracker circuit may include two output switching circuits, and may be configured to supply a plurality of discrete voltages to six power amplifiers via six external connection terminals.

Fig. 13 is a partial circuit diagram of a tracker circuit according to another embodiment. In Fig. 13, the tracker circuit includes output switching circuits 31 and 32, filter circuits 41B, 41D, 42B, and 42D, external connection terminals 141 to 146, and switches S55, S56, S5B, and S5C to S5G.

The external connection terminals 144 to 146 are each connected to a different power amplifier (not illustrated). The external connection terminals 144 to 146 are terminals for supplying a plurality of discrete voltages V_{T4} to V_{T6}, respectively.

The output switching circuits 31 and 32 each have a configuration similar to that of the output switching circuit 30.

As with the filter circuit 40B, the filter circuits 41B and 42B each include inductors L51 and L52, and a capacitor C51.

As with the filter circuit 40D, the filter circuits 41D and 42D each include an inductor L53, and a capacitor C52.

The switch S5C is connected between the voltage supply path P42 and the external connection terminal 146. Closing of the switch S5C allows the output switching circuit 31 to output a plurality of discrete voltages also to the external connection terminal 146. That is, the output switching circuit 31 is capable of outputting a plurality of discrete voltages to the external connection terminal 146 in addition to the external connection terminals 141 to 143.

The switches S5D to S5G correspond to the switches S55, S56, S5B, and S5C, respectively. The output switching circuit 32 is thus capable of outputting a plurality of discrete voltages to the external connection terminal 143 in addition to the external connection terminals 144 to 146.

In the circuit configuration in Fig. 3, 9, 10, or 12, the tracker circuit 1A, 1B, 1C, or 1D may further include any one or more additional filter circuits on the voltage supply path P41.

For example, in the circuit configuration in Fig. 3, any additional filter circuit may be connected between the output switching circuit 30, and a node on the voltage supply path P41 to which the switch S55 is connected. In another example, any additional filter circuit may be connected between the node on the voltage supply path P41 to which the switch S55 is connected, and the external connection terminal 141. As with, for example, the filter circuit 40A, such any additional filter circuits may include an inductor and a capacitor.

For example, in the circuit configuration in Figs. 9, 10, or 12, any additional filter circuit may be connected between the output switching circuit 30, and a node on the voltage supply path P41 to which the switch S55 is connected. In another example, any additional filter circuit may be connected between the node on the voltage supply path P41 to which the switch S55 is connected, and a node on the voltage supply path P41 to which the switch S56 is connected. In another example, any additional filter circuit may be connected between the node on the voltage supply path P41 to which the switch S56 is connected, and the external connection terminal 141. As with, for example, the filter circuit 40B, such any additional filter circuits may include an inductor and a capacitor.

### Industrial Applicability

The present invention can be used for a wide variety of communication devices such as mobile phones, as a tracker circuit that supplies voltage to a power amplifier.

### Reference Signs List

1A, 1B, 1C, 1D tracker circuit
2A, 2B, 2D power amplifier
3A, 3B, 3C, 3D filter
4A, 4B, 4C switch
5 RFIC
6A, 6B, 6D antenna
7A, 7D communication device
10 pre-regulator circuit
20 switched-capacitor circuit
30, 31, 32 output switching circuit
40A, 40B, 40D, 41B, 41D, 42B, 42D filter circuit
50 DC power supply
60 digital control circuit
61 first controller
62 second controller
80 integrated circuit
80a PR switch portion
80b SC switch portion
80c OS switch portion
80d filter switch portion
90 module laminate
90a, 90b major face
90e ground plane
91 resin member
92 shield electrode layer
100 tracker module
110, 131, 132, 133, 134 input terminal
111, 112, 113, 114, 130 output terminal
115, 116 inductor connection terminal
141, 142, 143, 144, 145, 146 external connection terminal
150 electrode
601, 602, 603, 604 control terminal
P41, P42, P43, P44, P45, P46 voltage supply path

## Claims

1. A tracker circuit comprising:
an output switching circuit configured to selectively output at least one of a plurality of discrete voltages to a first power amplifier and a second power amplifier, the first power amplifier being configured to amplify a first radio frequency signal of a first band, the second power amplifier being configured to amplify a second radio frequency signal of a second band;
a first voltage supply path connecting the output switching circuit and the first power amplifier;
a second voltage supply path connecting the output switching circuit and the second power amplifier; and
a first filter circuit connectable in shunt with the first voltage supply path and the second voltage supply path.

2. The tracker circuit according to Claim 1, further comprising
a first switch connected between the first voltage supply path and the first filter circuit,
wherein the first filter circuit includes a first inductor and a first capacitor that are connected in series between the first switch and ground.

3. The tracker circuit according to Claim 2,
wherein one terminal of the first switch is connected to the output switching circuit, and
wherein an other terminal of the first switch is connected to the first filter circuit and the second power amplifier.

4. The tracker circuit according to Claim 3,
wherein in a case where the first radio frequency signal is to be amplified by the first power amplifier,
(i) when the first radio frequency signal has a channel band width greater than or equal to a first threshold band width, the first switch is opened, and
(ii) when the first radio frequency signal has a channel band width less than the first threshold band width, the first switch is closed, and
wherein in a case where the second radio frequency signal is to be amplified by the second power amplifier, the first switch is closed.

5. The tracker circuit according to Claim 1, further comprising:
a first switch and a second switch that are connected in parallel between the first voltage supply path and the first filter circuit;
a third switch connected between the output switching circuit and the first power amplifier;
a fourth switch and a fifth switch that are connected in parallel between the second voltage supply path and the first filter circuit; and
a sixth switch connected between the output switching circuit and the second power amplifier,
wherein the first filter circuit includes a first inductor, a second inductor, and a first capacitor that are connected in series,
wherein one terminal of the first switch and one terminal of the second switch are connected to the first voltage supply path,
wherein one terminal of the fourth switch and one terminal of the fifth switch are connected to the second voltage supply path,
wherein an other terminal of the first switch and an other terminal of the fourth switch are connected to one end of the first inductor and one end of the second inductor,
wherein an other terminal of the second switch and an other terminal of the fifth switch are connected to an other end of the second inductor, and
wherein the first capacitor is connected between an other end of the first inductor and ground.

6. The tracker circuit according to Claim 5,
wherein in a case where the first radio frequency signal is to be amplified by the first power amplifier,
(i) when the first radio frequency signal has a channel band width greater than or equal to a first threshold band width, the third switch is closed, and the first switch, the second switch, the fourth switch, the fifth switch, and the sixth switch are opened,
(ii) when the first radio frequency signal has a channel band width greater than or equal to a second threshold band width and less than the first threshold band width, the first switch and the third switch are closed, and the second switch, the fourth switch, the fifth switch, and the sixth switch are opened, and
(iii) when the first radio frequency signal has a channel band width less than the second threshold band width, the second switch and the third switch are closed, and the first switch, the fourth switch, the fifth switch, and the sixth switch are opened, and
wherein in a case where the second radio frequency signal is to be amplified by the second power amplifier,
(i) when the second radio frequency signal has a channel band width greater than or equal to the first threshold band width, the sixth switch is closed, and the first switch, the second switch, the third switch, the fourth switch, and the fifth switch are opened,
(ii) when the second radio frequency signal has a channel band width greater than or equal to the second threshold band width and less than the first threshold band width, the fourth switch and the sixth switch are closed, and the first switch, the second switch, the third switch, and the fifth switch are opened, and
(iii) when the second radio frequency signal has a channel band width less than the second threshold band width, the fifth switch and the sixth switch are closed, and the first switch, the second switch, the third switch, and the fourth switch are opened.

7. The tracker circuit according to Claim 1, further comprising
a first switch and a second switch that are connected in parallel between the first voltage supply path and the first filter circuit,
wherein the first filter circuit includes a first inductor, a second inductor, and a first capacitor that are connected in series,
wherein one terminal of the first switch and one terminal of the second switch are connected to the first voltage supply path,
wherein an other terminal of the first switch is connected to one end of the first inductor and one end of the second inductor,
wherein an other terminal of the second switch is connected to an other end of the second inductor and the second power amplifier, and
wherein the first capacitor is connected between an other end of the first inductor and ground.

8. The tracker circuit according to Claim 7,
wherein in a case where the first radio frequency signal is to be amplified by the first power amplifier,
(i) when the first radio frequency signal has a channel band width greater than or equal to a first threshold band width, the first switch and the second switch are opened,
(ii) when the first radio frequency signal has a channel band width greater than or equal to a second threshold band width and less than the first threshold band width, the first switch is closed, and the second switch is opened, and
(iii) when the first radio frequency signal has a channel band width less than the second threshold band width, the first switch is opened, and the second switch is closed, and
wherein in a case where the second radio frequency signal is to be amplified by the second power amplifier,
(i) when the second radio frequency signal has a channel band width greater than or equal to the second threshold band width, the first switch is closed, and the second switch is opened, and
(ii) when the second radio frequency signal has a channel band width less than the second threshold band width, the first switch is opened, and the second switch is closed.

9. The tracker circuit according to Claim 7 or 8,
wherein the first band is included in a range of 3300 to 5000 MHz, and
wherein the second band is included in a range of 1427 to 2690 MHz.

10. The tracker circuit according to Claim 1,
wherein the output switching circuit is further configured to selectively output at least one of the plurality of discrete voltages to a third power amplifier,
wherein the third power amplifier is configured to amplify a third radio frequency signal of a third band,
wherein the tracker circuit further comprises:
a third voltage supply path connecting the output switching circuit and the third power amplifier;
a second filter circuit connectable in shunt with the first voltage supply path, the second voltage supply path, and the third voltage supply path;
a first switch and a second switch that are connected in parallel between the first voltage supply path and the first filter circuit; and
a third switch connected between the second voltage supply path and the second filter circuit,
wherein the first filter circuit includes a first inductor, a second inductor, and a first capacitor that are connected in series,
wherein the second filter circuit includes a third inductor and a second capacitor that are connected in series,
wherein one terminal of the first switch and one terminal of the second switch are connected to the first voltage supply path,
wherein an other terminal of the first switch is connected to one end of the first inductor and one end of the second inductor,
wherein an other terminal of the second switch is connected to an other end of the second inductor and the second power amplifier,
wherein the first capacitor is connected between an other end of the first inductor and ground,
wherein one terminal of the third switch is connected to the other end of the second inductor and the second power amplifier in the second voltage supply path,
wherein an other terminal of the third switch is connected to one end of the third inductor and the third power amplifier, and
wherein the second capacitor is connected between an other end of the third inductor and ground.

11. The tracker circuit according to Claim 10,
wherein in a case where the first radio frequency signal is to be amplified by the first power amplifier,
(i) when the first radio frequency signal has a channel band width greater than or equal to a first threshold band width, the first switch, the second switch, and the third switch are opened,
(ii) when the first radio frequency signal has a channel band width greater than or equal to a second threshold band width and less than the first threshold band width, the first switch is closed, and the second switch and the third switch are opened, and
(iii) when the first radio frequency signal has a channel band width less than the second threshold band width, the first switch is opened, and the second switch and the third switch are closed,
wherein in a case where the second radio frequency signal is to be amplified by the second power amplifier,
(i) when the second radio frequency signal has a channel band width greater than or equal to the second threshold band width, the first switch is closed, and the second switch and the third switch are opened, and
(ii) when the second radio frequency signal has a channel band width less than the second threshold band width, the first switch is opened, and the second switch and the third switch are closed, and
wherein in a case where the third radio frequency signal is to be amplified by the third power amplifier, the first switch is opened, and the second switch and the third switch are closed.

12. The tracker circuit according to Claim 10 or 11,
wherein the first band is included in a range of 3300 to 5000 MHz,
wherein the second band is included in a range of 1427 to 2690 MHz, and
wherein the third band is included in a range of 698 to 960 MHz.

13. The tracker circuit according to any one of Claims 7 to 12,
wherein the second inductor has a larger rated current than the first inductor.

14. A tracker circuit comprising:
a first external connection terminal connected to a first power amplifier;
a second external connection terminal connected to a second power amplifier;
an output switching circuit configured to selectively output at least one of a plurality of discrete voltages to the first external connection terminal and the second external connection terminal;
a first voltage supply path connecting the output switching circuit and the first external connection terminal;
a second voltage supply path connecting the output switching circuit and the second external connection terminal; and
a first filter circuit that is connected between the first voltage supply path and ground, and that is connected between the second voltage supply path and ground.

15. The tracker circuit according to Claim 14, further comprising
a first switch connected between the first voltage supply path and the first filter circuit,
wherein the first filter circuit includes a first inductor and a first capacitor that are connected in series between the first switch and ground.

16. The tracker circuit according to Claim 15,
wherein one terminal of the first switch is connected to the output switching circuit, and
wherein an other terminal of the first switch is connected to the first filter circuit and the second external connection terminal.

17. The tracker circuit according to Claim 14, further comprising:
a first switch and a second switch that are connected in parallel between the first voltage supply path and the first filter circuit;
a third switch connected between the output switching circuit and the first external connection terminal;
a fourth switch and a fifth switch that are connected in parallel between the second voltage supply path and the first filter circuit; and
a sixth switch connected between the output switching circuit and the second external connection terminal,
wherein the first filter circuit includes a first inductor, a second inductor, and a first capacitor that are connected in series,
wherein one terminal of the first switch and one terminal of the second switch are connected to the first voltage supply path,
wherein one terminal of the fourth switch and one terminal of the fifth switch are connected to the second voltage supply path,
wherein an other terminal of the first switch and an other terminal of the fourth switch are connected to one end of the first inductor and one end of the second inductor,
wherein an other terminal of the second switch and an other terminal of the fifth switch are connected to an other end of the second inductor, and
wherein the first capacitor is connected between an other end of the first inductor and ground.

18. The tracker circuit according to Claim 14, further comprising
a first switch and a second switch that are connected in parallel between the first voltage supply path and the first filter circuit,
wherein the first filter circuit includes a first inductor, a second inductor, and a first capacitor that are connected in series,
wherein one terminal of the first switch and one terminal of the second switch are connected to the first voltage supply path,
wherein an other terminal of the first switch is connected to one end of the first inductor and one end of the second inductor,
wherein an other terminal of the second switch is connected to an other end of the second inductor and the second external connection terminal, and
wherein the first capacitor is connected between an other end of the first inductor and ground.

19. The tracker circuit according to Claim 14, further comprising:
a third external connection terminal connected to a third power amplifier;
a third voltage supply path connecting the output switching circuit and the third external connection terminal;
a second filter circuit that is connected between the first voltage supply path and ground, that is connected between the second voltage supply path and ground, and that is connected between the third voltage supply path and ground;
a first switch and a second switch that are connected in parallel between the first voltage supply path and the first filter circuit,
a third switch connected between the second voltage supply path and the second filter circuit,
wherein the first filter circuit includes a first inductor, a second inductor, and a first capacitor that are connected in series,
wherein the second filter circuit includes a third inductor and a second capacitor that are connected in series,
wherein one terminal of the first switch and one terminal of the second switch are connected to the first voltage supply path,
wherein an other terminal of the first switch is connected to one end of the first inductor and one end of the second inductor,
wherein an other terminal of the second switch is connected to an other end of the second inductor and the second external connection terminal,
wherein the first capacitor is connected between an other end of the first inductor and ground,
wherein one terminal of the third switch is connected to the other end of the second inductor and the second external connection terminal in the second voltage supply path,
wherein an other terminal of the third switch is connected to one end of the third inductor and the third external connection terminal, and
wherein the second capacitor is connected between an other end of the third inductor and ground.

20. A tracking method comprising:
in a case where a first radio frequency signal of a first band is to be amplified by a first power amplifier,
(i) not connecting a filter circuit to a first voltage supply path when the first radio frequency signal has a channel band width greater than or equal to a threshold band width, and connecting the filter circuit to the first voltage supply path when the first radio frequency signal has a channel band width less than the threshold band width, and
(ii) selectively supplying at least one of a plurality of discrete voltages to the first power amplifier via the first voltage supply path; and
in a case where a second radio frequency signal of a second band is to be amplified by a second power amplifier,
(i) connecting the filter circuit to a second voltage supply path, and
(ii) selectively supplying at least one of a plurality of discrete voltages to the second power amplifier via the second voltage supply path.
